# EUROPEAN PATENT APPLICATION

(11) **EP 4 842 176 A1**
(43) Date of publication of application: **18.11.2026**
(21) Application number: 25739154.0
(22) Date of filing: 10.01.2025
(51) Int. Cl.: H10K 59/124, H10K 59/121, H10K 59/131, H10K 59/123

(54) **DISPLAY PANEL**

(30) Priority: 12.01.2024 KR 20240005447
(71) Applicant: Samsung Display Co., Ltd., Yongin-si, Gyeonggi-do 17113 (KR)
(72) Inventor: YANG, Shinhyuk, Yongin-si, Gyeonggi-do 17113 (KR); LEE, Woogeun, Yongin-si, Gyeonggi-do 17113 (KR); KANG, Donghan, Yongin-si, Gyeonggi-do 17113 (KR); KIM, Jeehoon, Yongin-si, Gyeonggi-do 17113 (KR); MOON, Sunggwon, Yongin-si, Gyeonggi-do 17113 (KR); LEE, Keumhee, Yongin-si, Gyeonggi-do 17113 (KR)
(74) Representative: Marks & Clerk LLP
(86) International application number: PCT/KR2025/000657
(87) International publication number: WO 2025/150994

(57) **Abstract**

Provided is a display panel. The display panel includes a transistor, a first conductive layer including a first connection pattern connected to the transistor, a first inorganic layer configured to cover the first conductive layer, a first organic layer disposed on the first inorganic layer, a second conductive layer disposed on the first organic layer and including a second connection pattern that is connected to the first connection pattern, a second inorganic layer configured to cover the second conductive layer, a second organic layer disposed on the second inorganic layer, a light emitting element disposed on the second organic layer and connected to the second connection pattern, a contact hole passing through the second inorganic layer to expose at least a portion of the second conductive layer, and an opening spaced apart from the contact hole on a plane and passing through the second inorganic layer to expose at least a portion of the first organic layer.

## Description

### [Technical Field]

The present disclosure herein relates to a display panel, and more particularly, to a display panel having improved process reliability.

### [Background Art]

Multimedia electronic devices such as televisions, mobile phones, tablet computers, navigators, game consoles, and the like include a display panel. A display panel may include a plurality of pixels, and each pixel may include a light emitting element that generates light and a driving element connected to the light emitting element.

In the light emitting element, a display panel including an organic light emitting element has advantages such as a wide viewing angle, a fast response speed, and low power consumption, and are attracting attention as next-generation electronic devices. However, as an area of the electronic device becomes larger, stability in voltage supplied depending on the area is deteriorated, resulting in luminance unevenness.

### [Disclosure]

### [Technical Problem]

The present disclosure provides a display panel having improved process reliability. The present disclosure also provides a display panel having high resolution.

### [Technical Solution]

An embodiment of the inventive concept provides a display panel including: a substrate comprising a display area and a peripheral area adjacent to the display area; a transistor disposed in the display area; a first conductive layer disposed on the transistor and including a first connection pattern connected to the transistor; a first inorganic layer configured to cover the first conductive layer; a first organic layer disposed on the first inorganic layer; a second conductive layer disposed on the first organic layer and including a second connection pattern that is connected to the first connection pattern by passing through the first inorganic layer and the first organic layer; a second inorganic layer configured to cover the second conductive layer; a second organic layer disposed on the second inorganic layer; a light emitting element disposed on the second organic layer and connected to the second connection pattern; a contact hole passing through the second inorganic layer to expose at least a portion of the second conductive layer; and an opening spaced apart from the contact hole on a plane and passing through the second inorganic layer to expose at least a portion of the first organic layer.

In an embodiment, the second connection pattern may be connected to the first connection pattern through the contact hole.

In an embodiment, the second organic layer may be in contact with the first organic layer through the opening.

In an embodiment, the opening may be provided in plurality, which are arranged to be spaced apart from each other.

In an embodiment, one and the other of the plurality of openings may have different shapes on the plane.

In an embodiment, the opening may not overlap the second connection pattern on the plane.

In an embodiment, the second conductive layer may further include a plurality of conductive patterns spaced apart from the second connection pattern on the plane, and the opening may not overlap the conductive patterns on the plane.

In an embodiment, in the display area, a ratio of an area of the opening on the plane to an area of the second inorganic layer on the plane may be about 30% or less.

In an embodiment, the first conductive layer may further include a pad electrically connected to the transistor and disposed in the peripheral area, and a first pad opening through which the pad is exposed may be defined in the first inorganic layer.

In an embodiment, the second inorganic layer may not overlap the first pad opening on the plane.

In an embodiment, a second pad opening overlapping the first pad opening may be defined in the second inorganic layer.

In an embodiment, the first pad opening and the second pad opening may be aligned with each other on the plane.

In an embodiment, each of the first connection pattern and the pad may include a first sub-layer, a second sub-layer disposed on the first sub-layer, and a third sub-layer disposed on the second sub-layer and including a material different from that of the second sub-layer, and the third sub-layer of the first connection pattern may have a thickness different from that of the third sub-layer of the pad.

In an embodiment of the inventive concept, a display panel includes: a substrate including a display area including a plurality of emission areas and a peripheral area adjacent to the display area; a transistor disposed in each of the emission areas; a first conductive layer disposed on the transistor and including a plurality of first conductive patterns spaced apart from each other; a first inorganic layer configured to cover the first conductive layer; a first organic layer disposed on the first inorganic layer; a second conductive layer disposed on the first organic layer and including a plurality of second conductive patterns spaced apart from each other; a second inorganic layer configured to cover the second conductive layer; a second organic layer disposed on the second inorganic layer; and a light emitting element disposed in each of the emission areas, disposed on the second organic layer, and connected to the transistor through a first connection pattern of the first conductive patterns and a second connection pattern of the second conductive patterns, wherein the second inorganic layer includes an opening spaced apart from the second conductive patterns on a plane, and the second organic layer is in contact with the first organic layer through the opening.

In an embodiment, the light emitting element may be connected to the second connection pattern through a contact hole passing through the second organic layer and the second inorganic layer, and the opening may be spaced apart from the contact hole on the plane.

In an embodiment, the opening may have an area greater than that of the contact hole.

In an embodiment, the opening may be defined in each of the emission areas.

In an embodiment, the opening may be provided in plurality, which are spaced apart from each other within each of the emission areas.

In an embodiment, the first conductive layer may further include a pad disposed in the peripheral area, and a first pad opening through which the pad is exposed may be defined in the first inorganic layer.

In an embodiment, a second pad opening overlapping the first pad opening may be defined in the second inorganic layer.

### [Advantageous Effects]

According to the embodiments of the inventive concept, the display panel having the process reliability may be provided.

### [Description of Drawings]

FIG. 1 is a perspective view of an electronic device according to an embodiment of the inventive concept;
FIG. 2 is an exploded perspective view of an electronic device according to an embodiment of the inventive concept;
FIG. 3 is a cross-sectional view of a display module according to an embodiment of the inventive concept;
FIG. 4A is a plan view of a display panel according to an embodiment of the inventive concept;
FIG. 4B is an equivalent circuit diagram of a pixel according to an embodiment of the inventive concept;
FIG. 4C is a cross-sectional view illustrating a portion of the display panel;
FIG. 5A is a plan view illustrating a lamination order of conductive patterns provided in a unit pixel according to an embodiment of the inventive concept;
FIG. 5B is a cross-sectional view illustrating a portion of a display panel according to an embodiment of the inventive concept;
FIGS. 6A to 6M are plan views in which the lamination order of the conductive patterns provided in a unit pixel is divided for each layer according to an embodiment of the inventive concept;
FIG. 7A is a cross-sectional view illustrating a portion of a display panel according to a comparative example of the inventive concept;
FIG. 7B is a cross-sectional view illustrating a portion of a display panel according to an embodiment of the inventive concept;
FIGS. 8A to 8C are cross-sectional views of the display panel according to an embodiment of the inventive concept;
FIGS. 9A to 9D are plan views illustrating a partial area of the display panel of the display panel according to an embodiment of the inventive concept;
FIGS. 10A to 10F are plan views illustrating a partial area of the display panel of the display panel according to an embodiment of the inventive concept; and
FIGS. 11A to 11F are plan views illustrating a partial area of the display panel of the display panel according to an embodiment of the inventive concept.

### [Mode for Invention]

In this specification, it will also be understood that when one component (or region, layer, portion) is referred to as being 'on', 'connected to', or 'coupled to' another component, it can be directly disposed/connected/coupled on/to the one component, or an intervening third component may also be present.

Like reference numerals refer to like elements throughout. Also, in the figures, the thickness, ratio, and dimensions of components are exaggerated for clarity of illustration.

The term "and/or" includes any and all combinations of one or more of the associated listed items.

It will be understood that although the terms such as 'first' and 'second' are used herein to describe various elements, these elements should not be limited by these terms. These terms are used only to distinguish one component from other components. For example, a first element referred to as a first element in an embodiment can be referred to as a second element in another embodiment without departing from the scope of the appended claims. The terms of a singular form may include plural defines unless referred to the contrary.

Also, ""under", "below", "above', "upper", and the like are used for explaining relation association of components illustrated in the drawings. The terms may be a relative concept and described based on directions expressed in the drawings.

Unless otherwise defined, all terms (including technical and scientific terms) used herein have the same meaning as commonly understood by a person of ordinary skill in the art to which the inventive concept belongs. Also, terms such as defined terms in commonly used dictionaries are to be interpreted as having meanings consistent with meaning in the context of the relevant art and are expressly defined herein unless interpreted in an ideal or overly formal sense.

The meaning of "include" or "comprise" specifies a property, a fixed number, a step, an operation, an element, a component or a combination thereof, but does not exclude other properties, fixed numbers, steps, operations, elements, components or combinations thereof.

Hereinafter, embodiments of the inventive concept will be described with reference to the accompanying drawings.

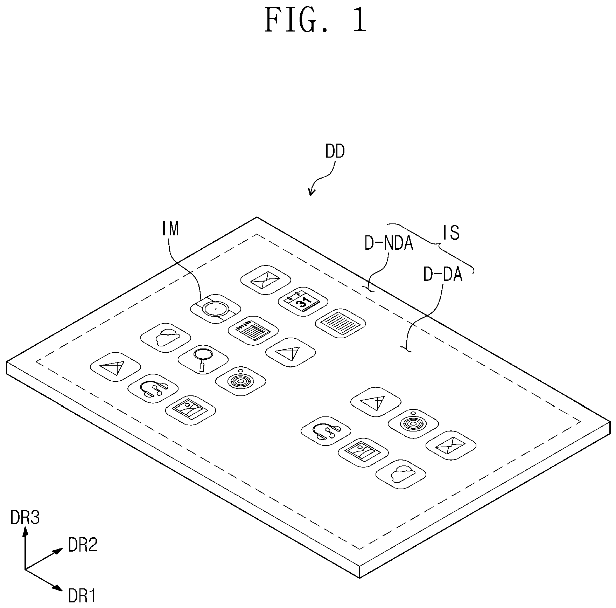

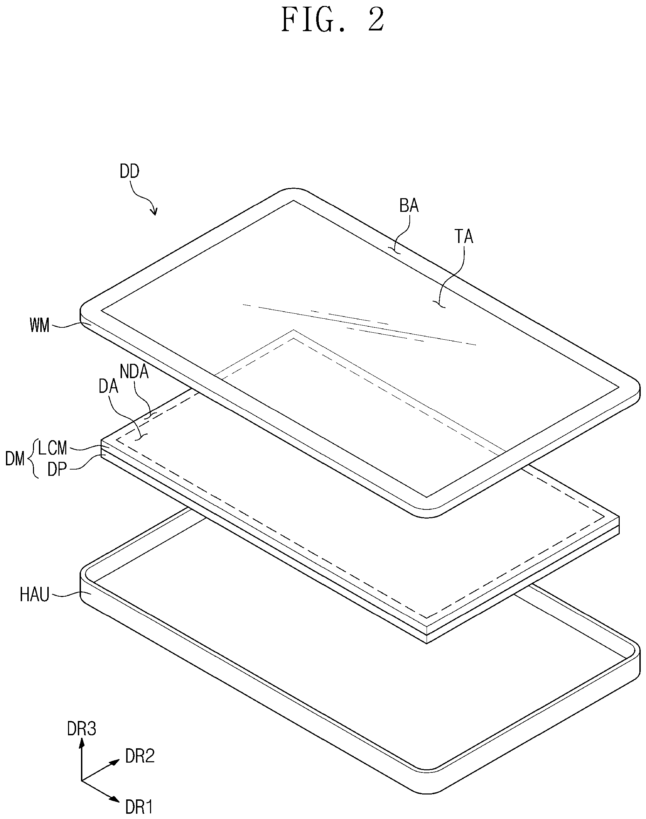

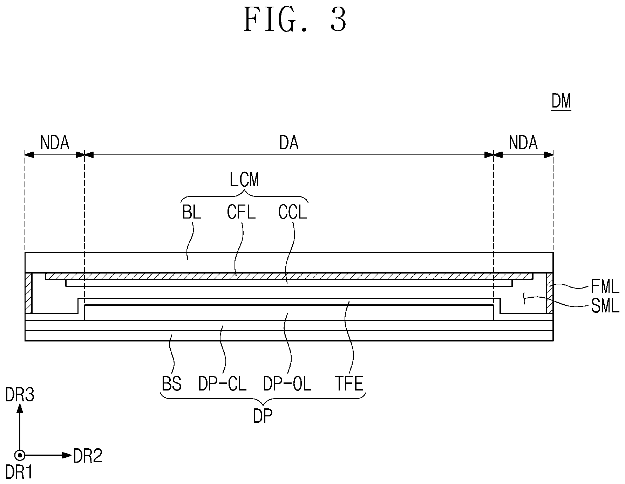

FIG. 1 is a perspective view of an electronic device according to an embodiment of the inventive concept. FIG. 2 is an exploded perspective view of an electronic device according to an embodiment of the inventive concept. FIG. 3 is a cross-sectional view of a display module according to an embodiment of the inventive concept.

The electronic device DD may be a device that is activated according to an electrical signal to display an image. The electronic device DD may include various embodiments. For example, the electronic device DD may include large-sized devices such as televisions, external billboards and the like, and small and medium-sized devices such as monitors, mobile phones, tablet computers, navigation systems, game consoles, and the like. The embodiments of the electronic device DD are merely examples and are not limited thereto unless departing from the concept of the present disclosure.

The first to third directional axes DR1 to DR3 are illustrated in FIG. 1 and following drawings, and directions indicated by the first to third directional axes DR1, DR2, and DR3, which are described in this specification, may be relative concepts and thus may be changed into different directions. Also, directions indicated by the first to third direction axes DR1, DR2, and DR3 may be described as first to third directions, and the same reference numerals may be used.

A thickness direction of the electronic device DD may be a direction parallel to the third directional axis DR3, which is a normal direction to the plane defined by the first directional axis DR1 and the second directional axis DR2. In this specification, a front surface (or top surface) and a rear surface (or bottom surface) of each of members constituting the electronic device DD may be defined based on the third directional axis DR3.

The electronic device DD may display an image IM in the third direction DR3 on a display surface IS parallel to a surface defined in the first and second directions DR1 and DR2. The third direction DR3 may be parallel to a normal direction of the display surface IS. The display surface IS on which the image IM is displayed may correspond to a front surface of the electronic device DD. The image IM may include a still image as well as a dynamic image. FIG. 1 illustrates icon images as an example of the image IM.

In this specification, the term "on the plane" may be defined as a state when viewed in the third direction DR3. In this specification, "on the cross-section" may be defined as a state when viewed from the first direction DR1 or the second direction DR2. The directions indicated as the first to third directions DR1, DR2, and DR3 may be a relative concept and thus changed into different directions.

FIG. 1 illustrates an example of the electronic device DD having the planar display surface IS. However, a shape of the display surface IS of the electronic device DD is not limited thereto and may have a curved or three-dimensional shape.

The electronic device DD may be a flexible display device. The term "flexible" means a bendable property and may include a structure that is completely folded to a few nanometers. For example, the flexible electronic device DD may include a curved display device and a foldable display device. However, the embodiment of the inventive concept is not limited thereto, and the electronic device DD may be a rigid display device.

The display surface IS of the electronic device DD may include a display area D-DA and a peripheral area D-NDA. The image IM may be displayed on the display area D-DA. The user may visually recognize the image IM through the display area D-DA. In an embodiment illustrated in FIG. 1 or the like, the display area D-DA is illustrated in a rectangular shape, but this shape is an example, and the display area D-DA may have various shapes.

The peripheral area D-NDA may be a non-display portion that does not display the image IM. The peripheral area D-NDA may have a predetermined color and may correspond to a portion that blocks light. The peripheral area D-NDA may be adjacent to the display area D-DA. For example, the peripheral area D-NDA may be disposed outside at least one side of the display area D-DA, and the peripheral area D-NDA may surround the display area D-DA. However, this is shown as an example, and the peripheral area D-NDA may be adjacent to only one side of the display area D-DA or may be disposed on a side surface rather than the front surface of the electronic device DD, but is not limited thereto. For example, the peripheral area D-NDA may be omitted.

The electronic device DD according to an embodiment may sense an external input applied from the outside. The external input may have various forms such as a pressure, a temperature, and light provided from the outside. The external input may include an input that is in contact with the electronic device DD (e.g., contact by a user's hand or a pen) as well as an input that is applied in proximity to the electronic device (DD) (e.g., hovering).

Referring to FIGS. 2 and 3, the display device DD may include a window WM, a display module DM, and a housing HAU, and the display module DM may include a display panel DP and a light control member LCM. The window WM and the housing HAU may be coupled to each other to define an outer appearance of the electronic device DD and provide an internal space to accommodate components of the electronic device DD such as the display module DM.

The window WM may be disposed on the display module DM. The window WM may protect the display module DM from an external impact. A front surface of the window WM may correspond to the display surface IS of the electronic device DD described above. The front surface of the window WM may include a transmission area TA and a bezel area BA.

The transmission area TA of the window WM may be an optically transparent area. The window WM may transmit the image provided by the display module DM through the transmission area TA, and the user may visually recognize the image. The transmission area TA may correspond to the display area D-DA of the electronic device DD.

The display module DM may display an image according to an electrical signal. The display module DM may include a display area DA and a non-display area NDA adjacent to the display area DA.

The display area DA may be a portion corresponding to the display area D-DA (see FIG. 1) of the electronic device DD. The display area DA may be an area that is activated according to an electrical signal. The display area DA may be an area that emits the image provided from the display module DM. The display area DA of the display module DM may correspond to the transmission area TA described above. In this specification, that "area/portion and area/portion corresponds to each other" means "overlapping with each other", but is not limited to having the same area and/or the same shape. The image displayed on the display area DA may be visually recognized from the outside through the transmission area TA.

The non-display area NDA may be adjacent to the display area DA. For example, the non-display area NDA may surround the display area DA. However, the embodiment of the inventive concept is not limited thereto, and the non-display area NDA may be defined in various shapes. The non-display area NDA may correspond to the peripheral area D-NDA (see FIG. 1) of the electronic device DD. The non-display area NDA may be an area on which a driving circuit or driving line for driving elements disposed on the display area DA, various signal lines providing electrical signals, and pads are disposed. The non-display area NDA of the display module DM may correspond to the bezel area BA described above. The components of the display module DM disposed on the non-display area NDA may be prevented from being visually recognized to the outside by the bezel area BA.

The display panel DP according to an embodiment may be an emission type display panel, but is not particularly limited thereto. For example, the display panel DP may be an organic light emitting display panel, an inorganic light emitting display panel, or a quantum dot light emitting display panel. An emission layer of the organic light emitting display panel may include an organic light emitting material, and an emission layer of the inorganic light emitting display panel may include an inorganic light emitting material. An emission layer of the quantum dot light emitting display panel may include a quantum dot, a quantum rod, and the like. Hereinafter, the display panel DP is described as an organic light emitting display panel.

The display panel DP may include a base substrate BS, a circuit layer DP-CL, a display element layer DP-OL, and an encapsulation layer TFE. Each layer of the display panel DP will be described in more detail later.

The light control member LCM may be disposed on the display panel DP. The light control member LCM may be provided on the display panel DP and then coupled to the display panel DP through a bonding process using a sealing member SML.

However, the light control member LCM is not limited thereto and may be directly disposed on the display panel DP. In this specification, the formation using a continuous process without a separate adhesive layer or adhesive member may be expressed as being "directly disposed." For example, the expression "the light control member LCM is disposed directly on the display panel DP" means that, after the display panel DP is formed, components of the light control member LCM are formed on the base surface provided by the display panel DP through the continuous process.

The sealing member SLM may be disposed in the non-display area NDA, which is an outer portion of the display module DM, to prevent foreign substances, oxygen, and moisture from being introduced into the display module DM from the outside. The sealing member SLM may be made of a sealant including a curable resin.

In addition, the display module DM according to an embodiment may further include a filling layer FML disposed between the display panel DP and the light control member LCM. The filling layer FML may fill a space between the display panel DP and the light control member LCM. The filling layer FML may function as a buffer between the display panel DP and the light control member LCM. In an embodiment, the filling layer FML may perform an impact absorbing function, etc., and may allow the display module DM to increase in strength. The filling layer FML may be made of a filling resin including a polymer resin. For example, the filling layer FML may be made of a filling layer resin including an acrylic resin or an epoxy resin. In an embodiment, the filling layer FML and the sealing member SML may be omitted, and the light control member LCM may be disposed directly on the display panel DP, and also, the base layer BL may be omitted from the light control member LCM.

The light control member LCM may include light control patterns that are capable of converting optical properties of source light provided by the display panel DP. The light control member LCM may selectively convert a wavelength or color of the source light or transmit the source light. The light control member LCM may control a color purity or color gamut of light emitted from the electronic device DD and prevent reflection of external light incident from the outside of the electronic device DD. For example, in an embodiment, the light control member LCM may include quantum dots that convert the wavelength of the source light provided from the display panel DP. In addition, in an embodiment, the light control member LCM may include a light control layer CCL including quantum dots and a color filter CFL disposed on the light control layer CCL. The light control layer CCL and the color filter CFL may be disposed on the base layer BL of the light control member.

The housing HAU may be disposed below the display module DM to accommodate the display module DM. The housing HAU may absorb an impact applied from the outside to prevent foreign substances/moisture, etc., from being permeated into the display module DM, thereby protecting the display module DM. The housing HAU according to embodiment may be provided in a form in which a plurality of accommodation members are coupled to each other.

The display module DM may further include an input sensing unit. The input sensing unit may acquire coordinate information of an external input applied from the outside of the display device DD. The input sensing unit may be disposed between the display panel DP and the light control member LCM. For example, the input sensing unit may be disposed directly on the display panel DP through the continuous process, but is not limited thereto, and may be manufactured separately to be attached to the display panel DP through an adhesive layer.

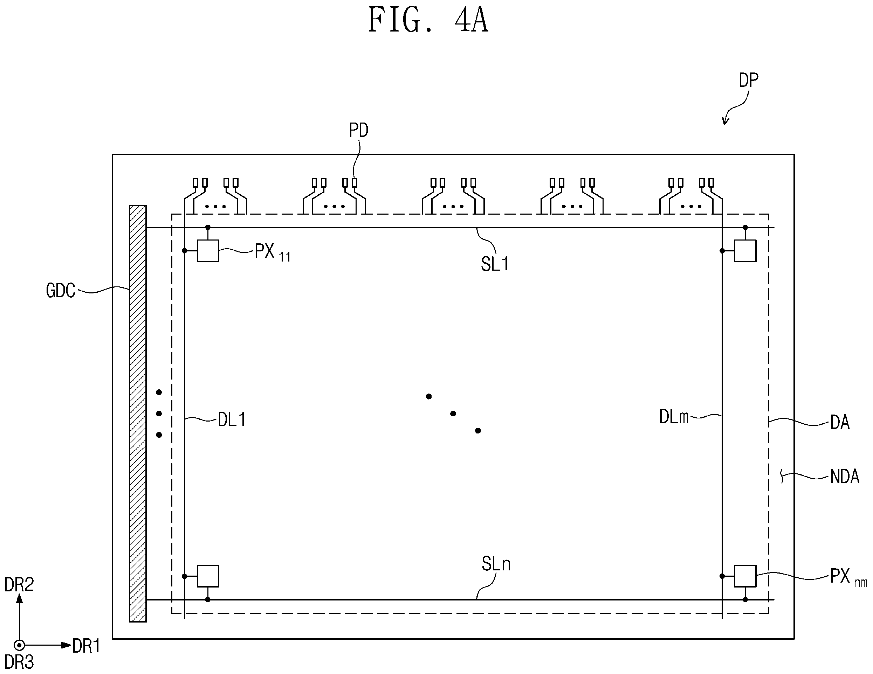

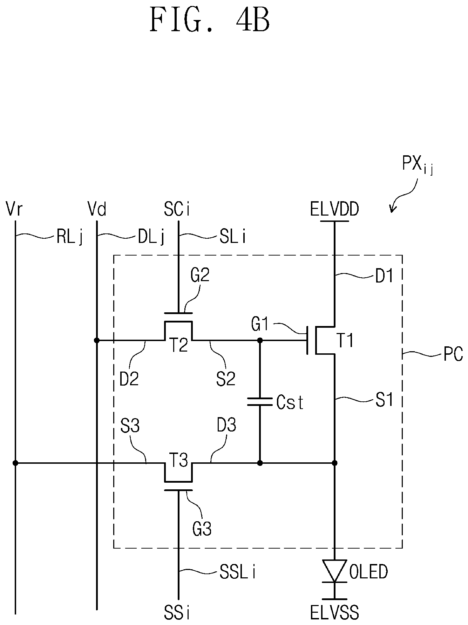

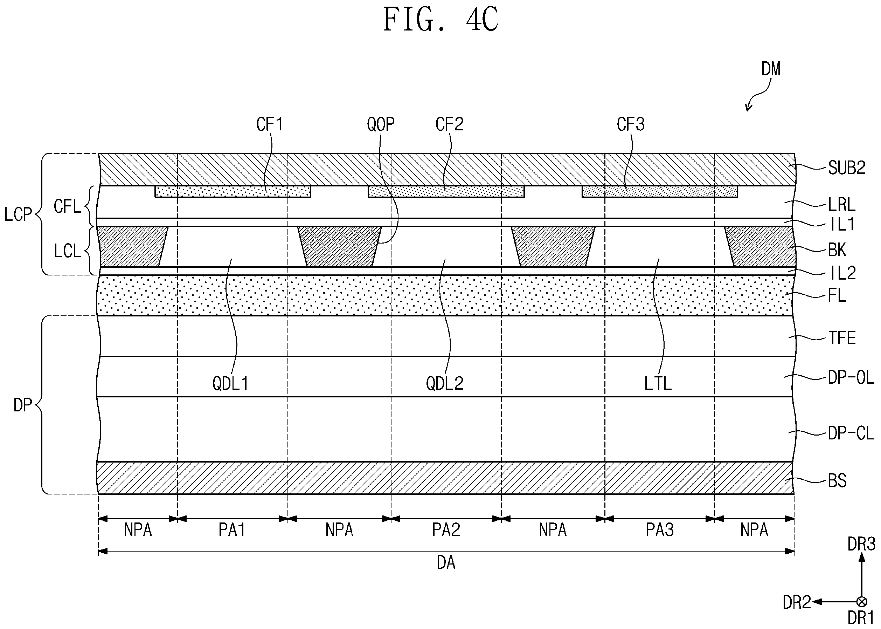

FIG. 4A is a plan view of the display panel according to an embodiment of the inventive concept. FIG. 4B is an equivalent circuit diagram of a pixel according to an embodiment of the inventive concept. FIG. 4C is a cross-sectional view illustrating a portion of the display panel.

Referring to FIG. 4A, the display panel DP may include pixels PX11 to PXnm disposed in the display area DA and signal lines SL1 to SLn and DL1 to DLm electrically connected to the pixels PX11 to PXnm. The display panel DP may include a driving circuit GDC and pads PD disposed on the non-display area NDA.

Each of the pixels PX11 to PXnm may include a pixel driving circuit constituted by a light emitting element, a plurality of transistors (e.g., a switching transistor, a driving transistor, etc.) connected to the light emitting element, and a capacitor, which will be described below. Each of the pixels PX11 to PXnm may emit light in response to an electrical signal applied to the pixel. FIG. 3A illustrates the pixels PX11 to PXnm arranged in a matrix form as an example, but the arrangement of the pixels PX11 to PXnm is not limited thereto.

The signal lines SL1 to SLn and DL1 to DLm may include scan lines SL1 to SLn and data lines DL1 to DLm. Each of the pixels PX11 to PXnm may be connected to a corresponding scan line of the plurality of scan lines SL1 to SLn and a corresponding data line of the plurality of data lines DL1 to DLm. More types of signal lines may be provided in the display panel DP according to the configuration of the pixel driving circuit.

The driving circuit GDC may include a gate driving circuit. The gate driving circuit may generate gate signals and sequentially output the gate signals to the scan lines SL1 to SLn. The gate driving circuit may further output another control signal to the pixel driving circuit of the pixels PX11 to PXnm.

The driving circuit GDC and the pixels PX11 to PXnm according to an embodiment may include a plurality of thin film transistors (TFTs) formed through a low temperature polycrystalline silicon (LTPS) process, a low temperature polycrystalline oxide (LTPO) process, or an oxide semiconductor process.

The pads PD may be arranged along one direction on the non-display area NDA. The pads PD may be a portion connected to the circuit board. Each of the pads PD may be connected to a corresponding signal line of the signal lines SL1 to SLn and DL1 to DLm and may be electrically connected to a corresponding pixel through the signal line. The pads PD may have a shape integrated with the signal lines SL1 to SLn and DL1 to DLm. However, this embodiment is not limited thereto, and the pads PD may be disposed on a layer different from that, on which the signal lines SL1 to SLn and DL1 to DLm are disposed, and be connected through a contact hole.

FIG. 4B illustrates a pixel PXij connected to an i-th scan line SLi, an i-th sensing line SSLi, a j-th data line DLj, and a j-th reference line RLj as an example. Referring to FIG. 4B, the pixel PXij may include a pixel circuit PC and a light emitting element OLED connected to the pixel circuit PC.

The pixel circuit PC may include a plurality of transistors T1, T2, an T3 and a capacitor Cst. The plurality of transistors T1, T2, and T3 may include a first transistor T1 (or driving transistor), a second transistor T2 (or switch transistor), and a third transistor T3 (or sensing transistor). Each of the first to third transistors T1, T2, and T3 may be a thin film transistor.

The first to third transistors T1, T2, and T3 may be NMOS transistors, but are not limited thereto and may be PMOS transistors. The first to third transistors T1, T2, and T3 may include sources S1, S2, and S3, drains D1, D2, and D3, and gates G1, G2, and G3, respectively.

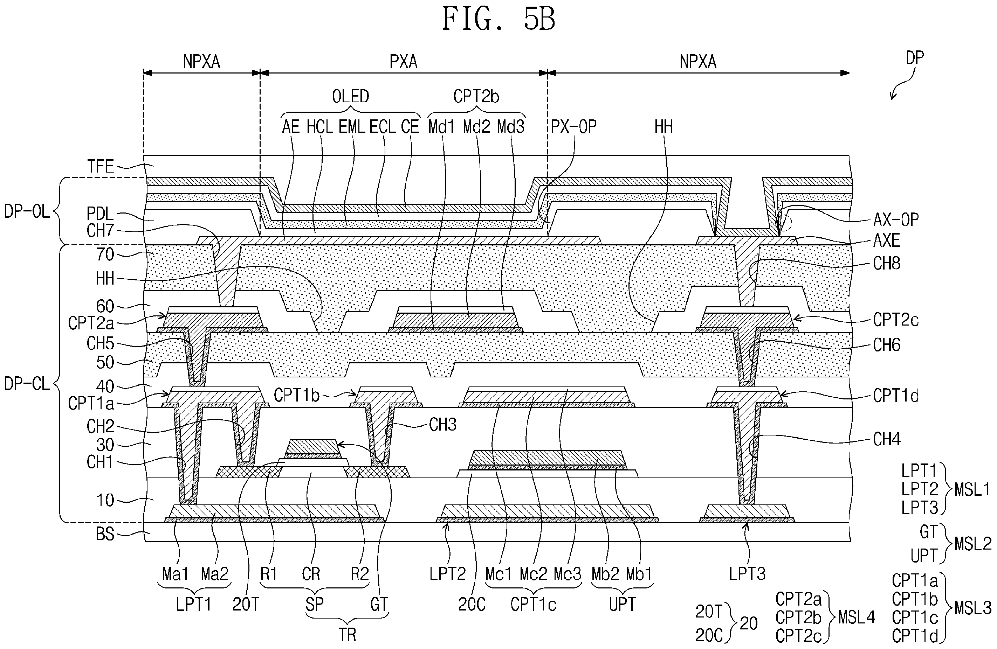

The light emitting element OLED may be an organic light emitting element including a first electrode AE (see FIG. 5B) and a second electrode CE (see FIG. 5B). The first electrode AE may be referred to as an anode or a pixel electrode, and the second electrode may be referred to as a cathode or a common electrode. The first electrode AE (see FIG. 5B) of the light emitting element OLED may receive a first voltage ELVDD through the driving transistor T1, and the second electrode CE (see FIG. 5B) of the light emitting element OLED may receive a second voltage ELVSS. The light emitting element OLED may receive the first voltage ELVDD and the second voltage ELVSS to emit light.

The driving transistor T1 may include a drain D1 receiving the first voltage ELVDD, a source S1 connected to the first electrode AE (see FIG. 5B) of the light emitting element OLED, and a gate G1 connected to the capacitor Cst. The driving transistor T1 may control driving current flowing through the light emitting element OLED at the first voltage ELVDD in response to a voltage value stored in the capacitor Cst.

The switch transistor T2 may include a drain D2 connected to an j-th data line DLj, a source S2 connected to the capacitor Cst and a gate G1 of the driving transistor T1, and a gate G2 that receives an i-th write scan signal SCi. The j-th data line DLj may receive a data voltage Vd and a data voltage for sensing. The switch transistor T2 may transmit the data voltage Vd input from the j-th data line DLj to the driving transistor T1 according to a switching voltage input from the i-th write scan signal SCi.

The sensing transistor T3 may include a source S3 connected to an j-th reference line RLj, a drain D3 connected to the first electrode AE (see FIG. 5B) of the light emitting element OLED, and a gate G3 that receives an i-th sampling scan signal SSi. The j-th reference line RLj may receive a reference voltage Vr.

The capacitor Cst may be connected to the gate G1 of the driving transistor T1 and the first electrode AE of the light emitting element OLED (see FIG. 5B). The capacitor Cst may include a first capacitor electrode connected to the gate G1 of the driving transistor T1 and a second capacitor electrode connected to the first electrode AE (see FIG. 5B) of the light emitting element OLED. The capacitor Cst may store a voltage corresponding to a difference between a voltage transmitted from the switch transistor T2 and the first voltage ELVDD.

The equivalent circuit of the pixel PXij illustrated in FIG. 4B is illustrated as an example for one pixel PXij, and the equivalent circuit for the pixels PX11 to PXnm is not limited to that illustrated in FIG. 4B. In another embodiment of the inventive concept, the equivalent circuit diagram of the pixel PXij may be implemented in various forms to allow the light emitting element OLED to emit light.

FIG. 4C simply illustrates a cross-section corresponding to emission areas corresponding to three pixels of the pixels PX11 to PXnm illustrated in FIG. 4A. One emission area may be an area in which light generated by one light emitting element provided in one pixel is displayed. As an example, in FIG. 4C, a circuit element layer DP-CL, a display element layer DP-OL, a thin film encapsulation layer TFE, and a filler FL are illustrated together with a color filter layer CFL and a light conversion layer LCL. In addition, in FIG. 4C, the circuit element layer DP-CL, the display element layer DP-OL, and the thin film encapsulation layer TFE are illustrated as a single layer.

Referring to FIG. 4C, the display area DA may include a first emission area PA1, a second emission area PA2, a third emission area PA3, and a non-emission area NPA disposed around each of the first to third emission areas PA1, PA2, and PA3. The first to third emission areas PA1, PA2, and PA3 may generate first light having the same color. For example, the first light may be blue light. However, this is described as an example, and the first to third emission areas PA1, PA2, and PA3 may be areas that emit light having two or more colors, but are not limited to any one embodiment.

The color filter layer CFL may include a first color filter CF1, a second color filter CF2, a third color filter CF3, a low refractive index layer LRL, and a first insulating layer IL1. For example, one first color filter CF1, one second color filter CF2, and one third color filter CF3 are illustrated, but in reality, each of the first color filter CF1, the second color filter CF2, and the third color filters CF3 may be provided in plurality.

The light conversion layer LCL may include a first quantum dot layer QDL1, a second quantum dot layer QDL2, a light transmission layer LTL, a bank layer BK, and a second insulating layer IL2. One first quantum dot layer QDL1, one second quantum dot layer QDL2, and one light transmission layer LTL are illustrated as an example, but in reality, each of the first quantum dot layer QDL1, the second quantum dot layer QDL2 and the light transmission layer LTL may be provided in plurality.

The first color filter CF1, the second color filter CF2, and the third color filter CF3 may be disposed below a second substrate SUB2. In the plan view, the first color filter CF1 may overlap the first emission area PA1, the second color filter CF2 may overlap the second emission area PA2, and the third color filter CF3 may overlap the third emission area PA3. The first color filter CF1 may include a red color filter. The second color filter CF2 may include a green color filter. The third color filter CF3 may include a blue color filter.

The low refractive layer LRL may be disposed below the second substrate SUB2 to cover the first to third color filters CF1, CF2, and CF3. The low refractive index layer LRL may have a refractive index less than that of each of the first quantum dot layer QDL1, the second quantum dot layer QDL2, and the light transmission layer LTL. The low refractive index layer LRL may include an organic layer and a plurality of scattering particles disposed within the organic layer to scatter light. The first insulating layer IL1 may be disposed below the low refractive index layer LRL. The first insulating layer IL1 may include an inorganic layer.

The bank layer BK may be disposed below the first insulating layer IL1. When viewed on the plane, the bank layer BK may overlap the non-emission area NPA. Openings QOP that overlap the first to third emission areas PA1, PA2, and PA3 may be defined in the bank layer BK. A width of each of the openings QOP may be greater than that of the aforementioned pixel opening. The bank layer BK may have a black color.

The first and second quantum dot layers QDL1 and QDL2 and the light transmission layer LTL may be disposed in the openings QOP. Thus, the first and second quantum dot layers QDL1 and QDL2 and the light transmission layer LTL may overlap the first, second, and third emission areas PA1, PA2 and PA3, respectively. The first quantum dot layer QDL1 may overlap the first emission area PA1, the second quantum dot layer QDL2 may overlap the second emission area PA2, and the light transmission layer LTL may overlap the third emission area PA3.

The second insulating layer IL2 may be disposed below the bank layer BK, the first and second quantum dot layers QDL1 and QDL2, and the light transmission layer LTL. The second insulating layer IL2 may include an inorganic layer.

First light L1 generated in the first to third emission areas PA1, PA2 and PA3 may be provided to the first and second quantum dot layers QDL1 and QDL2 and the light transmission layer LTL. The first light L1 generated in the first emission area PA1 may be provided to the first quantum dot layer QDL1, and the first light L1 generated in the second emission area PA2 may be provided to the second quantum dot layer QDL2. The first light L1 generated in the third emission area PA3 may be provided to the light transmission layer LTL.

The first quantum dot layer QDL1 may convert the first light L1 into second light L2. The second quantum dot layer QDL2 may convert the first light L1 into third light L3. For example, the second light L2 may be red light, and the third light L3 may be green light. The first quantum dot layer QDL1 may include first quantum dots, and the second quantum dot layer QDL2 may include second quantum dots. The light transmission layer LTL may include light scattering particles.

The first quantum dots may convert the first light L1 having a blue wavelength band into the second light L2 having a red wavelength band. The second quantum dots may convert the first light L1 having the blue wavelength band into the third light L3 having a green wavelength band. The first and second quantum dots may scatter the second and third light L2 and L3, respectively.

The light transmission layer LTL may transmit the first light L1 without performing a light conversion operation. The first light L1 may be scattered and emitted by the light scattering particles of the light transmission layer LTL. The light scattering particles may be contained in the first and second quantum dot layers QDL1 and QDL2.

The first quantum dot layer QDL1 may emit the second light L2, the second quantum dot layer QDL2 may emit the third light L3, and the light transmission layer LTL may emit the first light L1. Thus, an image may be displayed by the second light L2, the third light L3, and the first light L1 displaying red, green, and blue colors.

The first to third lights L1, L2, and L3 emitted from the light conversion layer LCL may be provided to the user by passing through the low refractive layer LRL, the first, second, and third color filters CF1, CF2, and CF3, and the second substrate SUB2. The first to third lights L1, L2, and L3 may be refracted in the low refractive index layer LRL and then further scattered by the scattering particles disposed in the low refractive index layer LRL.

A portion of the first light L1 may be provided to the first color filter CF1 by passing through the first quantum dot layer QDL1 without being light-converted by the first quantum dots. That is, because the first light L1 is not in contact with the first quantum dots, the first light L1 that is not converted into the second light L2 may exist. The first color filter CF1 may block light having different colors. The first light L1 that is not converted in the first quantum dot layer QDL1 may be blocked by the first color filter CF1 having the red color filter and thus may not be emitted upward.

A portion of the first light L1 may be provided to the second color filter CF2 by passing through the second quantum dot layer QDL2 without being light-converted by the second quantum dots. That is, because the first light L1 is not in contact with the second quantum dots, the first light L1 that is not converted into the third light L3 may exist. The second color filter CF2 may block light having a different color. The first light L1 that is not converted in the second quantum dot layer QDL2 may be blocked by the second color filter CF2 having the green color filter and thus may not be emitted upward.

External light may be provided from the display device DD toward the display panel DP. The external light may be white light. The white light may include red light, green light, and blue light. If the first to third color filters CF1, CF2, and CF3 are not used, the external light may be reflected by metal layers (e.g., lines) inside the display panel DP and then provided to an external user as it is. In this case, the external light may be viewed by the user, such as light reflected from a mirror.

The first to third color filters CF1, CF2, and CF3 may prevent the external light from being reflected. The first to third color filters CF1, CF2, and CF3 may filter the external light into light having red, green, and blue colors.

Specifically, the green light and blue light of the external light provided to the first color filter CF1 may be blocked by the first color filter CF1 including the red color filter. Thus, the external light provided to the first color filter CF1 may be filtered by the first color filter CF1 as the same red light as the light emitted from the first quantum dot layer QDL1.

The red light and blue light of the external light provided to the second color filter CF2 may be blocked by the second color filter CF2 that is the green color filter. Thus, the external light provided to the second color filter CF2 may be filtered by the second color filter CF2 into the same green light as the light emitted from the second quantum dot layer QDL2.

The red light and green light of the external light provided to the third color filter CF3 may be blocked by the third color filter CF3 that is the blue color filter. Thus, the external light provided to the third color filter CF3 may be filtered by the third color filter CF3 into the same blue light as the light emitted from the light transmission layer LTL. Thus, the external light may be blocked by the first to third color filters CF1, CF2, and CF3, and the reflection of the external light may be reduced.

The black bank layer BK may block unnecessary light in the non-emission area NPA. For example, the bank layer BK may prevent color mixing between the first light L1, the second light L2, and the third light L3 in the non-emission area NPA.

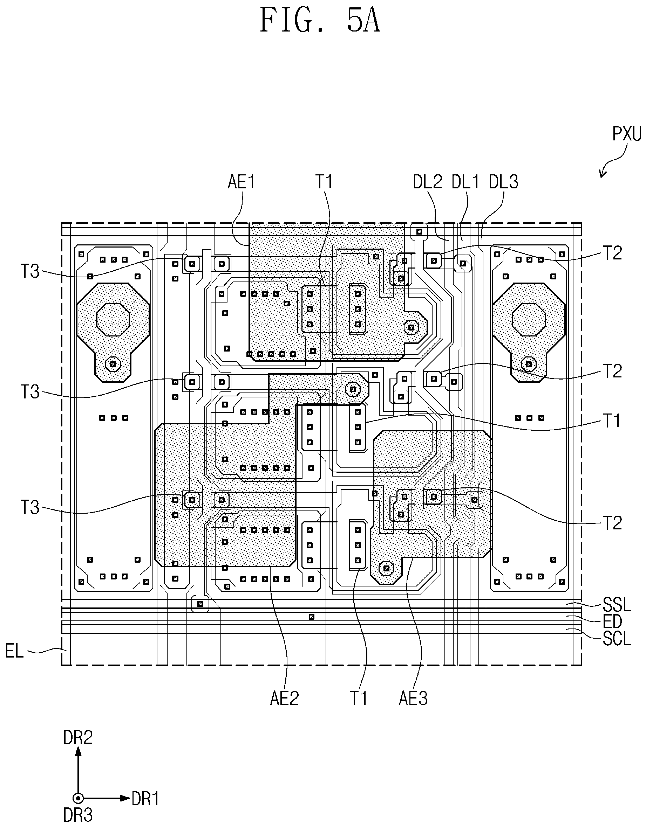

FIG. 5A is a plan view illustrating a lamination order of conductive patterns provided in a unit pixel according to an embodiment of the inventive concept. FIG. 5B is a cross-sectional view illustrating a portion of a display panel according to an embodiment of the inventive concept. FIG. 5B illustrates a portion corresponding to one emission area PXA and a non-emission area NPXA adjacent thereto in the emission areas shown in FIG. 5A. Hereinafter, the inventive concept will be described with reference to FIGS. 5a and 5B. The same reference numeral may be given to components that are the same as those of FIGS. 1 to 4C, and their detailed descriptions will be omitted.

FIG. 5A shows an arrangement relationship of three pixels provided in one unit pixel PXU and components provided in the driving element. In FIG. 5A, among the signal lines connected to each of the pixels, a first power line ED, a second power line EL, a scan line SCL, a sensing line SSL, and data lines DL1, DL2, and DL3 are illustrated. Each of the pixels is connected to a first power line ED, a second power line EL, a scan line SCL, and a sensing line SSL. Also, the pixels may be connected to the corresponding data lines DL1, DL2, and DL3. The first power line ED may provide the first voltage ELVDD, and the second power line EL may provide the second voltage ELVSS (see FIG. 4B) that is lower than the first voltage ELVDD. This is illustrated as an example, and the number or arrangement of pixels and the number or arrangement of signal lines provided in the unit pixel PXU may be changed in various manner and are not limited to any one embodiment.

Each of the pixels according to the inventive concept may include the first to third transistors T1, T2, and T3, the capacitor Cst, and the light emitting element OLED (see FIG. 4B). FIG. 5A illustrates the first electrodes AE1, AE2, and AE3 of the light emitting element OLED provided in each of pixels PX1, PX2, and PX3. An equivalent circuit diagram relating to the first to third transistors T1, T2, and T3 and the capacitor Cst, which are provided in one of the pixels, may correspond to that described in FIG. 4B.

Referring to FIG. 5B, the display panel DP may include the base substrate BS, the circuit layer DP-CL, the display element layer DP-OL, and the encapsulation layer TFE, which are sequentially laminated. The display panel DP may include insulating layers, a semiconductor pattern, a conductive pattern, a signal line, and the like. In a process of manufacturing the display panel DP, the insulating layer, the semiconductor layer, and the conductive layer may be formed on the base substrate BS through coating, deposition, etc. Thereafter, the insulating layer, the semiconductor layer, and the conductive layer may be selectively patterned in a photolithography manner. The semiconductor pattern, the conductive pattern, the signal line, and the like provided in the circuit layer DP-CL may be formed through the processes. The semiconductor pattern of the circuit layer DP-CL may be arranged in a predetermined rule across the pixels.

The base substrate BS may include a glass substrate, a metal substrate, a semiconductor substrate, a polymer substrate, or an organic/inorganic composite material substrate. The base substrate BS may have a single-layer or multilayer structure. For example, the base substrate BS having the multilayer structure may include synthetic resin layers and at least one inorganic layer disposed between the synthetic resin layers.

The synthetic resin layer of the base substrate BS may include at least one of an acrylate-based resin, a methacrylate-based resin, a polyisoprene-based resin, a vinyl-based resin, an epoxy-based resin, a urethane-based resin, a cellulose-based resin, a siloxane-based resin, a polyamide-based resin, a perylene-based resin, or a polyimide-based resin. However, the material of the synthetic resin layer of the base substrate BS is not limited to the above examples.

The circuit layer DP-CL may be disposed on the base substrate BS. The circuit layer DP-CL may include a plurality of transistors, at least one capacitor, and a plurality of insulating layers that constitute the pixel circuit PC (FIG. 4B). In the display panel DP according to an embodiment, the circuit layer DP-CL may include lower conductive patterns LPT1, LPT2, and LPT3, a transistor TR, a second conductive layer MSL2, a third conductive layer MSL3, second source conductive patterns CPT1 and CPT2, and insulating layers 10, 20, 30, 40, 50, 60, and 70. The insulating layers 10, 10, 20, 30, 40, 50, 60, and 70 may include first to seventh insulating layers 10, 20, 30, 40, 50, 60, and 70 which are sequentially disposed. However, this is illustrated as an example, and it is obvious that the circuit layer DP-CL may further include additional insulating layers between, below, or above the insulating layers 10, 20, 30, 40, 50, 60, and 70.

Each of the insulating layers 10, 20, 30, 40, 50, 60, and 70 may include an inorganic layer or an organic layer and may have a single-layer structure or a multilayer structure. The inorganic layer may include at least one of aluminium oxide, titanium oxide, silicon oxide, silicon nitride, silicon oxynitride, zirconium oxide, or hafnium oxide, but is not limited to the above materials. The organic layer may include a phenol-based polymer, an acrylic-based polymer, an imide-based polymer, an aryl ether-based polymer, an amide-based polymer, a fluorine-based polymer, a p-xylene-based polymer, a vinyl alcohol-based polymer, and a polymer using a combination thereof, but is not limited to the above materials.

In FIG. 5B, only one transistor TR electrically connected to the light emitting element OLED is illustrated, but as illustrated in FIG. 3B, one pixel PXij may include a plurality of transistors for driving the light emitting element OLED.

The lower conductive patterns LPT1, LPT2, and LPT3 may be disposed between the base substrate BS and the first insulating layer 10. In this embodiment, each of the lower conductive patterns LPT1, LPT2, and LPT3 may have a laminated structure. Each of the lower conductive patterns LPT1, LPT2, and LPT3 may include a first layer Ma1 and a second layer Ma2, which are laminated in a thickness direction. In an embodiment, a thickness of the second layer Ma2 and a thickness of the first layer Ma1 may be different from each other. For example, in an embodiment, the thickness of the second layer Ma2 may be greater than the thickness of the first layer Ma1. However, the embodiment of the inventive concept is not limited thereto.

Each of the first layer Ma1 and the second layer Ma2 may be made of molybdenum (Mo), aluminium (Al), chromium (Cr), gold (Au), titanium (Ti), nickel (Ni), neodymium (Nd), and copper (Cu) or an alloy thereof. For example, the first layer Ma1 may include titanium (Ti), and the second layer Ma2 may include copper (Cu). However, the embodiment of the inventive concept is not limited thereto.

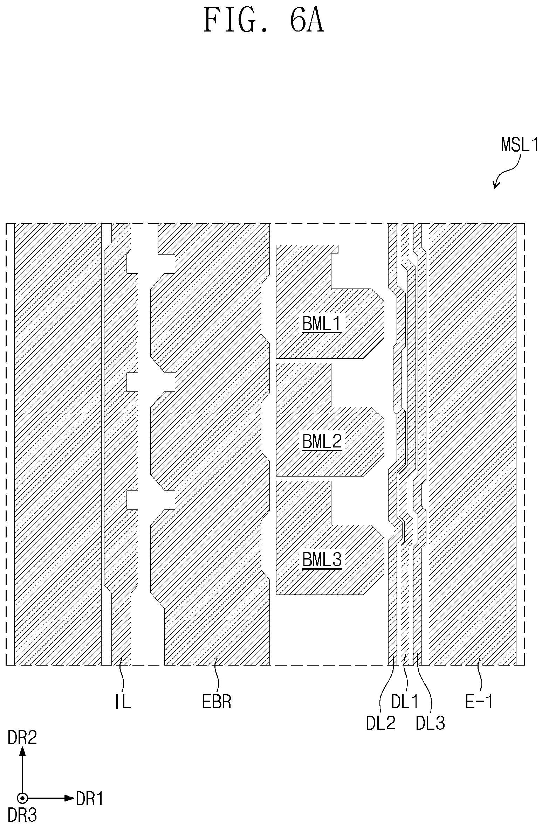

The lower conductive patterns LPT1, LPT2, and LPT3 may correspond to the first conductive layer MSL1 (see FIG. 6A), which will be described later. The lower conductive patterns LPT1, LPT2, and LPT3 may include a first lower conductive pattern LPT1, a second lower conductive pattern LPT2, and a third lower conductive pattern LPT3, of which at least some are spaced apart from each other. The first insulating layer 10 may be disposed on the base substrate BS to cover the lower conductive patterns LPT1, LPT2, and LPT3. A space between the lower conductive patterns LPT1, LPT2, and LPT3 may be filled with the first insulating layer 10.

Alternatively, at least two of the first to third lower conductive patterns LPT1, LPT2, and LPT3 may be conductive patterns having an integrated shape, which are connected to each other. Here, the lower conductive patterns connected to each other may receive the same electrical signal.

The first lower conductive pattern LPT1 may be disposed to overlap the transistor TR (e.g., overlap in the third direction DR3). The first lower conductive pattern LPT1 may block light from being incident onto the semiconductor pattern of the transistor TR or may be electrically coupled to the transistor TR to control driving characteristics of the transistor TR. However, this is illustrated as an example, and the first lower conductive pattern LPT1 may not overlap the semiconductor pattern SP of the transistor TR on the plane.

For example, the first lower conductive pattern LPT1 may be one of light blocking patterns BML1, BML2, and BML3 (see FIG. 6A), which will be described later. Alternatively, the first lower conductive pattern LPT1 may correspond to or be electrically connected to a power pattern EBR (see FIG. 6A), which will be described later. The first lower conductive pattern LPT1 may have various configurations and connection relationships if included in the first conductive layer MSL1 (see FIG. 6A), but is not limited to any one embodiment.

The second lower conductive pattern LPT2 may be configured to form a capacitor with an upper conductive pattern UPT. For example, the second lower conductive pattern LPT2 may have an integral shape with the first lower conductive pattern LPT1. Alternatively, the second lower conductive pattern LPT2 may be a physically separated pattern that receives the same electrical signal as the first lower conductive pattern LPT1, or may be a conductive pattern that receives a different signal, for example, one of signal lines IL, EBR, DL1, DL2, DL3, and E-1 (see FIG. 6A) to be described later, but is not limited to any one embodiment.

The third lower conductive pattern LPT3 may be one of an initial line IL, a power pattern EBR, a plurality of light blocking patterns BML1, BML2, and BML3, first to third data lines DL1, DL2, and DL3, and the first line E-1. That is, the third lower conductive pattern LPT3 may be a pattern connected to at least one of the first and second lower conductive patterns LPT1 and LPT2, or may be a separated pattern. In this embodiment, the third lower conductive pattern LPT3 may be one of the signal lines transmitting the second voltage ELVSS (see FIG. 4B) or a conductive pattern connected thereto. For example, the third lower conductive pattern LPT3 may be the first line E-1. The first to third lower conductive patterns LPT1, LPT2, and LPT3 may have various configurations as long as the first to third lower conductive patterns LPT1, LPT2, and LPT3 are conductive patterns disposed between the base substrate BS and the first insulating layer 10, but are not limited to any one embodiment.

The first insulating layer 10 may be a buffer layer that improves bonding strength between the base substrate BS and the semiconductor pattern of the circuit layer DP-CL. The first insulating layer 10 may include at least one of aluminium oxide, titanium oxide, silicon oxide, silicon nitride, silicon oxynitride, zirconium oxide, or hafnium oxide, but is not limited to the above materials.

The film transistor TR may be disposed on the first insulating layer 10. The transistor TR may include a gate electrode GT and a semiconductor pattern SP. The transistor TR may be any one of the first to third transistors T1, T2, and T3 illustrated in FIG. 5A. The semiconductor pattern SP may include polysilicon. However, the embodiment of the inventive concept is not limited thereto, and the semiconductor pattern SP may include amorphous silicon or metal oxide.

In this embodiment, the source, the channel, and the drain of the transistor TR may be formed from the semiconductor pattern SP. The semiconductor pattern SP of the transistor TR may be divided into a plurality of regions R1, CR, and R2 depending on a degree of conductivity. For example, electrical properties of the semiconductor pattern SP may vary according to whether the semiconductor pattern SP is doped, or metal oxide is reduced. In the semiconductor pattern SP, the regions R1 and R2 having relatively high conductivity may serve as electrodes or signal lines, and each of the regions R1 and R2 may correspond to the source or the drain of the transistor TR. Hereinafter, in this embodiment, the first region R1 may be referred to as the source of the transistor TR, and the second region R2 may be referred to as the drain of the transistor TR.

A non-doped, doped at a relatively low concentration or non-reduced region of the semiconductor pattern SP may have relatively low conductivity, and the corresponding region may correspond to the channel CR of the transistor TR. However, this is illustrated as an example, and only the channel CR of the transistor TR may be defined in the semiconductor pattern SP, and the source R1 and drain R2 may be provided as separate conductive patterns like the gate electrode GT and be provided as being connected to the semiconductor pattern SP. The transistor TR according to an embodiment of the inventive concept may have various structures, but is not limited to any one embodiment.

The second insulating layer 20 may be disposed on the first insulating layer 10. The second insulating layer 20 may cover at least a portion of the semiconductor pattern SP of the circuit layer DP-CL. The second insulating layer 20 may be an inorganic layer. In this embodiment, a portion 20T of the second insulating layer 20 may be a gate insulating layer 20T covering the channel CR. The other portion 20C may be a capacitor insulating film 20C disposed on the first insulating layer 10, spaced apart from the semiconductor pattern SP, and overlapping the second lower conductive pattern LPT2. The gate insulating film 20T and the capacitor insulating film 20C may be separate patterns disposed on a plane and spaced apart from each other, or may be insulating patterns connected to each other and having an integrated shape. This is illustrated as an example, and the second insulating layer 20 may be provided in a shape that is disposed on the first insulating layer 10 to cover all of the semiconductor patterns of the circuit layer DP-CL, but is not limited to any one embodiment.

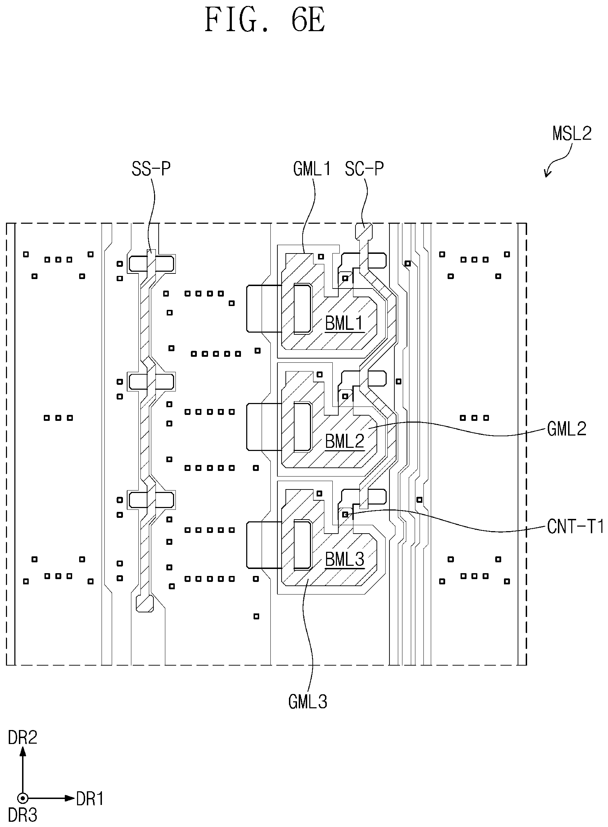

The gate electrode GT and the upper conductive pattern UPT may be disposed on the second insulating layer 20. The gate electrode GT and the upper conductive pattern UPT may constitute the second conductive layer MSL2 (see FIG. 6E), which will be described later. In this embodiment, the gate electrode GT and the upper conductive pattern UPT are illustrated to be spaced apart on the plane. The gate electrode GT and the upper conductive pattern UPT may be separate conductive patterns spaced apart from each other on the plane, or may be conductive patterns connected to each other and having an integrated shape, but are not limited to any one embodiment.

Specifically, the gate electrode GT may be disposed on the gate insulating film 20T. The gate electrode GT may function as a gate of the transistor TR by overlapping the channel CR of the transistor TR. The gate electrode GT may function as a mask in a process of doping the semiconductor pattern SP.

The upper conductive pattern UPT may be disposed on the capacitor insulating layer 20C. The upper conductive pattern UPT may overlap the second lower conductive pattern LPT2 on the plane to provide a capacitor. The capacitor insulating film 20C may be a dielectric of the capacitor together with the first insulating layer 10. The capacitor provided by the second lower conductive pattern LPT2 and the upper conductive pattern UPT may correspond to the capacitor Cst illustrated in FIG. 4B or may constitute a portion of the capacitor Cst.

The gate electrode GT and the upper conductive pattern UPT may be provided by simultaneously patterning the same material. Each of the gate electrode GT and the upper conductive pattern UPT may have a structure in which a plurality of layers are laminated. For example, the gate electrode GT and the upper conductive pattern UPT may include a first layer Mb1 and a second layer Mb2, which are sequentially laminated, respectively. However, the embodiment is not limited thereto, and each of the gate electrode GT and the upper conductive pattern UPT may be provided as a single layer, or three or more layers may be laminated.

Each of the gate electrode GT and the upper conductive pattern UPT may be made of a metal material. The gate electrode GT and the upper conductive pattern UPT may be made of molybdenum (Mo), aluminium (Al), chromium (Cr), gold (Au), titanium (Ti), nickel (Ni), neodymium (Nd), copper (Cu), and indium tin oxide (ITO), or an alloy thereof. For example, the first layer Mb1 may include titanium (Ti), and the second layer Mb2 may include copper (Cu). However, the embodiment of the inventive concept is not limited thereto.

A third insulating layer 30 may be disposed on the gate electrode GT and the upper conductive pattern UPT. The third insulating layer 30 may include an organic layer. The third insulating layer 30 may provide a flat top surface. However, the embodiment of the inventive concept is not limited thereto.

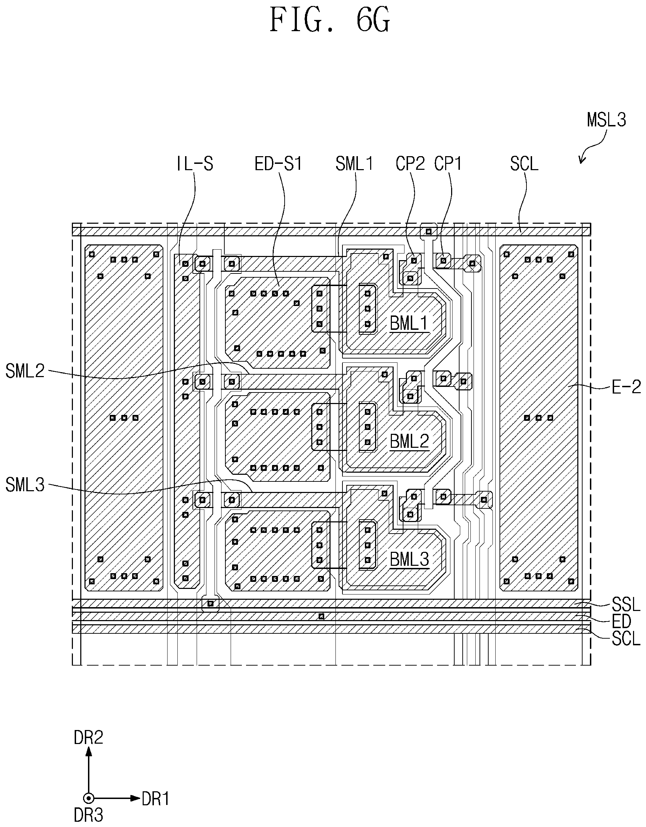

A plurality of first conductive patterns CPT1a, CPT1b, CPT1c, and CPT1d may be disposed on the third insulating layer 30. The first conductive patterns CPT1a, CPT1b, CPT1c, and CPT1d may correspond to the third conductive layer MSL3 (see FIG. 6G), which will be described later.

In this embodiment, the first conductive patterns CPT1a, CPT1b, CPT1c, and CPT1d may be formed by simultaneously patterning the same material. Each of the first conductive patterns CPT1a, CPT1b, CPT1c, and CPT1d may have a structure in which a plurality of layers are laminated. For example, each of the first conductive patterns CPT1a, CPT1b, CPT1c, and CPT1d may include a first sub-layer Mc1, a second sub-layer Mc2, and a third sub-layer Mc3, which are sequentially laminated. However, the embodiment is not limited thereto, and each of the first conductive patterns CPT1a, CPT1b, CPT1c, and CPT1d may be a single layer, two layers that are laminated, or four or more layers that are laminated.

The first conductive patterns CPT1a, CPT1b, CPT1c, and CPT1d may include a first connection electrode CPT1a, a second connection electrode CPT1b, a first pattern CPT1c, and a third connection electrode CPT1d. The first connection electrode CPT1a may be connected to the first lower conductive pattern LPT1 through a first contact hole CH1 passing through the third insulating layer 30 and the first insulating layer 10. In addition, the first connection electrode CPT1a may be connected to the source R1 through a second contact hole CH2 defined in the third insulating layer 30. In this embodiment, the first connection electrode CPT1a may be connected to a power line that supplies power to the light emitting element OLED. The first voltage ELVDD (see FIG. 4B) may be provided to the transistor TR through the power line. However, this is illustrated as an example, and the first connection electrode CPT1a may be selectively connected to only one of the first lower conductive pattern LPT1 and the source R1. Here, the first lower conductive pattern LPT1 may receive a voltage different from that of the source R1.

The second connection electrode CPT1b may be connected to the drain R2 of the transistor TR through a third contact hole CH3 passing through the third insulating layer 30. The drain R2 of the transistor TR may be electrically connected to other transistors, which constitute the pixel circuit, or signal lines connected to the pixel circuit through the second connection electrode CPT1b.

The first pattern CPT1c may be disposed at a position that overlaps the upper conductive pattern UPT on the plane. The first pattern CPT1c may provide a capacitor with the upper conductive pattern UPT and the third insulating layer 30 therebetween. Here, the second lower conductive pattern LPT2, the upper conductive pattern UPT, and the first pattern CPT1c may constitute one capacitor connected in series, which may correspond to the capacitor Cst illustrated in FIG. 4B. However, this is illustrated as an example, and the first pattern CPT1c may be disposed at a position that does not overlap the upper conductive pattern UPT, or may not provide a capacitor with the upper conductive pattern UPT, and may not form a capacitor with the upper conductive pattern UPT, but is not limited thereto.

The third connection electrode CPT1d may be connected to the third lower conductive pattern LPT3 through a fourth contact hole CH4 passing through the first and third insulating layers 10 and 30. The third connection electrode CPT1d may be a signal line transmitting the second power voltage ELVSS (see FIG. 4B) or a conductive pattern connected thereto.

The fourth insulating layer 40 may be disposed on the third insulating layer 30. The fourth insulating layer 40 may be an inorganic layer. For example, the fourth insulating layer 40 (hereinafter, referred to as a first inorganic layer) may include silicon oxide. However, the embodiment of the inventive concept is not limited thereto. The first inorganic layer 40 may be disposed on the third insulating layer 30 to cover the first conductive patterns CPT1a, CPT1b, CPT1c, and CPT1d. Spaces between the first conductive patterns CPT1a, CPT1b, CPT1c, and CPT1d may be covered by the first inorganic layer 40.

The fifth insulating layer 50 may be disposed on a fourth insulating layer 40. The fifth insulating layer 50 may be an organic layer. The fifth insulating layer 50 (hereinafter, referred to as the first organic layer) covers a curved top surface of the first inorganic layer 40 and provides a flat surface thereon.

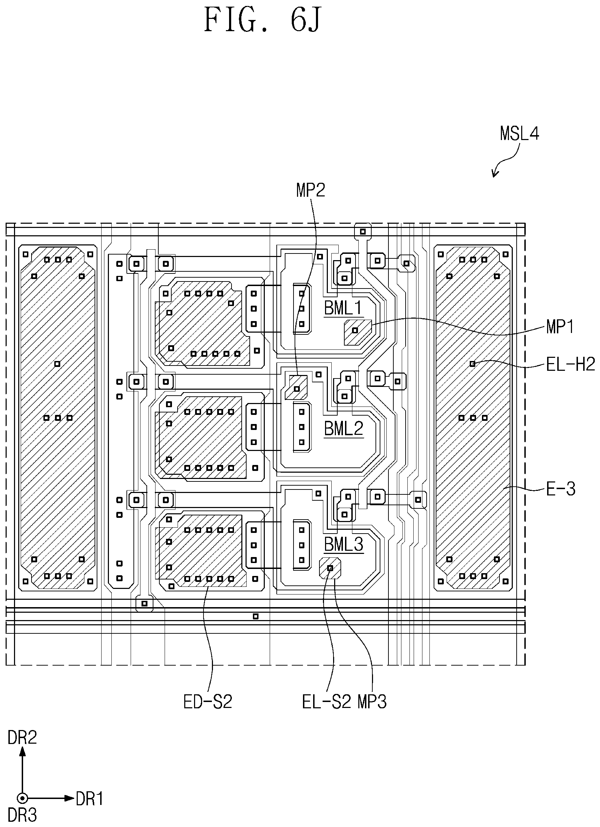

A plurality of second conductive patterns CPT2a, CPT2b, and CPT2c may be disposed on the first organic layer 50. The second conductive patterns CPT2a, CPT2b, and CPT2c may correspond to a fourth conductive layer MSL4 (see FIG. 6J), which will be described later. In this embodiment, the second conductive patterns CPT2a, CPT2b, and CPT2c may be formed by simultaneously patterning the same material. Each of the second conductive patterns CPT2a, CPT2b, and CPT2c may have a structure in which a plurality of layers are laminated. For example, the second conductive patterns CPT2a, CPT2b, and CPT2c may include a first sub-layer Md1, a second sub-layer Md2, and a third sub-layer Md3, which are sequentially laminated, respectively. However, this embodiment is not limited thereto, and each of the second conductive patterns CPT2a, CPT2b, and CPT2c may include two or less layers, or four or more layers that are stacked.

The second conductive patterns CPT2a, CPT2b, and CPT2c may include a fourth connection electrode CPT2a, a second pattern CPT2b, and a fifth connection electrode CPT2c, but are not limited thereto. The fourth connection electrode CPT2a, the second pattern CPT2b, and the fifth connection electrode CPT2c may be disposed to be spaced apart from each other on the first organic layer 50.

The fourth connection electrode CPT2a may be connected to the first connection electrode CPT1a through a fifth contact hole CH5 passing through the first inorganic layer 40 and the first organic layer 50. The fourth connection electrode CPT2a may correspond to a node connecting the light emitting element OLED illustrated in FIG. 4B to the source S1 of the first transistor T1.

The second pattern CPT2b may be spaced apart and electrically insulated from the fourth connection electrode CPT2a and the fifth connection electrode CPT2c on the plane. For example, the second pattern CPT2b may be data lines DL1, DL2, and DL3, a sensing line SSL, or a scan line SCL. Alternatively, the second pattern CPT2b may be a conductive pattern connected to either the fourth connection electrode CPT2a or the fifth connection electrode CPT2c, but is not limited to any one embodiment.

The fifth connection electrode CPT2c may be connected to the third connection electrode CPT1d through a sixth contact hole CH6 passing through the first inorganic layer 40 and the first organic layer 50. The fifth connection electrode CPT2c may be a power line transmitting the second power voltage ELVSS (see FIG. 4B) or a conductive pattern connected thereto.

A sixth insulating layer 60 (hereinafter, referred to as a second inorganic layer) is disposed on the first organic layer 50. The second inorganic layer 60 may include an inorganic material. For example, the second inorganic layer 60 may include silicon oxide. However, the embodiment of the inventive concept is not limited thereto. The second inorganic layer 60 covers the second conductive patterns CPT2a, CPT2b, and CPT2c. Specifically, the second inorganic layer 60 may cover all conductive patterns constituting the second conductive patterns CPT2a, CPT2b, and CPT2c, and also may cover each of the fourth connection electrode CPT2a, the second pattern CPT2b, and the fifth connection electrode CPT2c in FIG. 5B.

A seventh insulating layer 70 (hereinafter, referred to as a second organic layer) is disposed on the second inorganic layer 60. The second organic layer 70 includes an organic material. The second organic layer 70 covers the curved top surface of the second inorganic layer 60 and provides a flat surface thereon.

According to the inventive concept, the second conductive patterns CPT2a, CPT2b, and CPT2c may be additionally provided in addition to the first conductive patterns CPT1a, CPT1b, CPT1c, and CPT1d so that the connections between the pixel circuit components including the transistor TR, the capacitor Cst, and the light emitting element OLED is performed through the second conductive patterns CPT2a, CPT2b, and CPT2c as well as the first conductive patterns CPT1a, CPT1b, CPT1c, and CPT1d. Thus, an area occupied by circuit components for driving one light emitting element OLED may be reduced, and the display panel DP having high resolution may be easily provided.

At least one opening HH may be defined in the second inorganic layer 60 according to this embodiment. The opening HH may be defined at a position spaced apart from each of the conductive patterns constituting the second conductive patterns CPT2a, CPT2b, and CPT2c on the plane. That is, the opening HH does not overlap a third connection pattern and the second conductive pattern CPT2 on the plane. The opening HH passes through the second inorganic layer 60 and exposes a top surface of the first organic layer 50. Specifically, the opening HH may pass through a portion of the second inorganic layer 60 that covers a spaced space between the second conductive patterns CPT2a, CPT2b, and CPT2c, and the second organic layer 70 and the first organic layer 50 may be in contact with each other through the opening HH.

The opening HH may be a path through which air or a gas existing in the first organic layer 50 moves to the second organic layer 70. Bubbles or a gas transferred from the first organic layer 50 to the second organic layer 70 may be discharged to the outside together with bubbles or a gas existing in the second organic layer 70. According to the inventive concept, the opening HH may be defined in the second inorganic layer 60, the bubbles (air) or gas may not exist in the first organic layer 50 even if the inorganic layer 60 is provided on the first organic layer 50, but move to the second organic layer 70 through the opening HH. Thus, defects such as lifting or peeling of the second inorganic layer 60 due to the air or gas may be prevented from occurring. Thus, process reliability may be improved.

A display element layer DP-OL including a light emitting element OLED and a pixel defining layer PDL may be disposed on the circuit layer DP-CL. In addition, the display element layer DP-OL may include an encapsulation layer TFE disposed on the light emitting element OLED.

The light emitting element OLED and the pixel defining layer PDL may be disposed on the second organic layer 70. The light emitting element OLED may include a first electrode AE, a hole transport region HCL, an emission layer EML, an electron transport region ECL, and a second electrode CE, which are sequentially laminated. In the light emitting element OLED, the hole transport region HCL and the electron transport region ECL may be omitted or may be provided in a multiple layer structure, but are not limited to any one embodiment.

A pixel opening PX-OP may be defined in the pixel defining layer PDL corresponding to the emission area PXA. A portion of the first electrode AE of the light emitting element OLED may be exposed through the pixel opening PX-OP. The emission area PXA may correspond to the exposed portion of the first electrode AE.

The pixel defining layer PDL may include an organic material. For example, the pixel defining layer PDL may include a polyacrylate-based resin or a polyimide-based resin, but the material of the pixel defining layer PDL is not limited to the above examples. The pixel defining layer PDL may be made of an inorganic material. For example, the pixel defining layer PDL may include silicon nitride (SiNx), silicon oxide (SiOx), silicon nitride (SiOxNy), etc., but the material of the pixel defining layer PDL is not limited to the above examples.

The pixel defining layer PDL may include a light absorbing material or may have a predetermined color. For example, the pixel defining layer PDL may include a base resin and a black pigment and/or black dye mixed with the base resin.

The first electrode AE may be made of a metal material, a metal alloy, or a conductive compound. The first electrode AE may be a transmissive electrode, a transflective electrode or a reflective electrode. The first electrode AE may include Ag, Mg, Cu, Al, Pt, Pd, Au, Ni, Nd, Ir, Cr, Li, Ca, LiF/Ca (laminated structure of LiF and Ca), LiF/Al (LiF and Al (laminated structure), Mo, Ti, W, or a compound or mixture thereof (for example, a mixture of Ag and Mg). Alternatively, the first electrode AE may include the reflective layer or transflective layer, which is made of the above-described material, and a transparent conductive film including indium tin oxide (ITO), indium zinc oxide (IZO), zinc oxide (ZnO), or indium tin zinc oxide (ITZO). For example, the first electrode AE may include a first layer Ma1, a second layer Ma2, and a third layer, which are sequentially laminated. Specifically, the first electrode AE may have a three-layer structure including ITO in the first layer Ma1, Ag in the second layer Ma2, and ITO in the third layer CL3, but is not limited thereto.

The first electrode AE may be connected to the fourth connection electrode CPT2a through a seventh contact hole CH7 passing through the second inorganic layer 60 and the second organic layer 70. Thus, the first electrode AE may be electrically connected to the source S1 of the transistor TR.

The hole transport region HCL may be provided on the first electrode AE. The hole transport region HCL may have a single layer made of a single material, a single layer made of materials different from each other, or a multi-layered structure including a plurality of layers made of materials different from each other.

The hole transport region HCL may include at least one of a hole injection layer, a hole transport layer, and an electron blocking layer. In addition, the hole transport region HCL may include a plurality of laminated hole transport layers.

An emission layer EML may be disposed on the hole transport region HCL. The emission layer EML may have a single layer structure made of a single material, a single layer structure made of materials different from each other, or a multi-layered structure including a plurality of layers made of materials different from each other. In an embodiment, the light emission layer EML may emit blue light that serves as source light. However, this embodiment is not limited thereto, and the display element layer DP-OL may include light emitting elements OLED including an emission layer EML that emits light in different wavelength areas.

An electron transport region ECL may be disposed on the emission layer EML. The electron transport region ECL may have a single layer made of a single material, a single layer made of materials different from each other, or a multilayered structure including a plurality of layers made of materials different from each other. The electron transport region ECL may include at least one of an electron blocking layer, an electron transport layer, and an electron injection layer, but is not limited thereto.

Each of the hole transport region HCL, light emission layer EML, and electron transport region ECL may be formed using various methods such as vacuum deposition, spin coating, cast, langmuir-blodgett (LB), inkjet printing, laser printing, and laser induced thermal imaging (LITI).

The hole transport region HCL, the emission layer EML, and the electron transport region ECL may be provided as a common layer to overlap the entire plurality of emission areas PXA and the non-emission part NPXA. However, this embodiment is not limited thereto, and the emission layer EML may be provided by being patterned so as to correspond to only the emission area PXA and a portion of the non-emission portion NPXA adjacent to the emission area PXA.

The second electrode CE may be disposed on the electron transport region ECL. The second electrode CE may be a common electrode. That is, in the light emitting element OLED according to an embodiment, the second electrode CE may be provided as a common layer to overlap the entire plurality of emission areas PXA and the non-emission area NPXA.

The second electrode CE may include Ag, Mg, Cu, Al, Pt, Pd, Au, Ni, Nd, Ir, Cr, Li, Ca, LiF/Ca (laminated structure of LiF and Ca), LiF/Al (laminated structure of LiF and Al), Mo, Ti, Yb, W, or a compound or mixture thereof (e.g., AgMg, AgYb, or MgYb). Alternatively, the second electrode CE may include the reflective layer or transflective layer, which is made of the above-described material, and a transparent conductive film including indium tin oxide (ITO), indium zinc oxide (IZO), zinc oxide (ZnO), or indium tin zinc oxide (ITZO). For example, the second electrode CE may include the above-described metal material, a combination of two or more metal materials selected from the above-described metal materials, or oxide of the above-described metal materials.

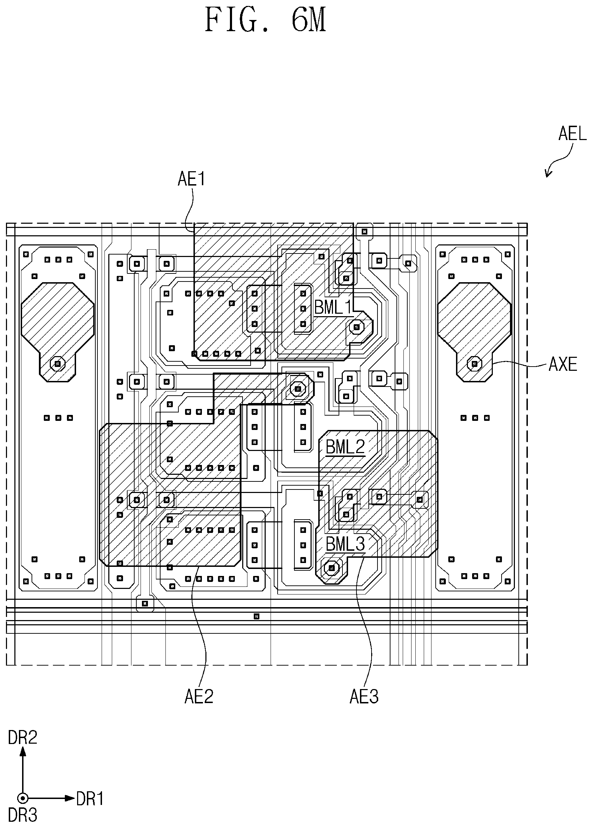

The second electrode CE may be connected to an auxiliary electrode AXE through an auxiliary opening AX-OP defined in the pixel defining layer PDL. The auxiliary electrode AXE may be disposed on the same layer as the first electrode AE. The auxiliary electrode AXE and the first electrode AE may correspond to the pixel electrode layer AEL (see FIG. 6M), which will be described later. The auxiliary electrode AXE may be disposed on the second organic layer 70 and connected to the fifth connection electrode CPT2c through an eighth contact hole CH8 defined to pass through the second inorganic layer 60 and the second organic layer 70. Thus, the second electrode CE may be electrically connected to a signal line transmitting the second power voltage ELVSS.

The encapsulation layer TFE may cover the light emitting element OLED. The encapsulation layer TFE may seal the display element layer DP-OL. The encapsulation layer TFE may be a thin film encapsulation layer. The encapsulation layer TFE may be provided as a single layer or a laminate in which a plurality of layers are laminated. The encapsulation layer TFE includes at least one insulating layer. The encapsulation layer TFE according to an embodiment may include at least one inorganic film (hereinafter, referred to as an encapsulating inorganic film). Also, the encapsulation layer TFE according to an embodiment of the inventive concept may include at least one organic layer (hereinafter, referred to as an encapsulating organic film) and at least one encapsulating inorganic film.

The encapsulation inorganic film protects the display element layer DP-OL against moisture/oxygen, and the encapsulation organic film protects the display element layer DP-OL against foreign substances such as dust particles. The encapsulating inorganic film may include silicon nitride, silicon oxy nitride, silicon oxide, titanium oxide, or aluminium oxide, but is not limited thereto. The encapsulating organic film may include an acrylic compound, an epoxy compound, or the like. The encapsulating organic film may include an organic material capable of photopolymerization, but is not particularly limited.

FIGS. 6A to 6M are plan views in which the lamination order of the conductive patterns provided in a unit pixel is divided for each layer according to an embodiment of the inventive concept. FIGS. 6A to 6M illustrate the configurations illustrated in FIG. 5B, which are distinguished for each layer based on the area illustrated in FIG. 5A. Hereinafter, the present disclosure will be described with reference to FIGS. 6A to 6M. An equivalent circuit diagram relating to the first to third transistors T1, T2, and T3 and the capacitor Cst, which are provided in one of the pixels, may correspond to that described in FIG. 4B.

Referring to FIG. 6A, a first conductive layer MSL1 according to the inventive concept may include an initial line IL, a power pattern EBR, a plurality of light blocking patterns BML1, BML2, BML3, first to third data lines DL1, DL2, and DL3, and a first line E-1 of the second power line EL. As described above, the first conductive layer MSL1 may correspond to the lower conductive patterns LPT1, LPT2, and LPT3 illustrated in FIG. 5B.

Each of the initial line IL and the power pattern EBR may extend along the second direction DR2, and the initial line IL and the power pattern EBR may be spaced apart from each other in the first direction DR1. The first to third data lines DL1, DL2, and DL3 may be spaced apart from each other in the first direction DR1, and each of the first to third data lines DL1, DL2 and DL3 may extend in the second direction DR2. FIGS. 6A to 6M illustrate the second data line DL2, the first data line DL1, and the third data line DL3, which are sequentially arranged in the first direction DR1, but this embodiment is not limited thereto. An arrangement order of the first to third data lines DL1, DL2, and DL3 may be changed and is not limited to any one embodiment. In addition, in this embodiment, the first to third data lines DL1, DL2, and DL3 are illustrated as being included in the first conductive layer MSL1, but this is not limited to the first to third data lines DL1, DL2, and DL3 may be disposed on a layer other than the first conductive layer MSL1, but is not limited to any one embodiment.

The first line E-1, which is disposed at the lowermost layer, of the second power line EL may extend in the second direction DR2. Thus, the first line E-1 may extend in the same direction as the first to third data lines DL1, DL2, and DL3 and the initial line IL. The first line E-1 may correspond to the third lower conductive pattern LPT3 (see FIG. 5B) described above. That is, the first line E-1 may be connected to an additional line E-12 of the third conductive layer MSL3, which will be described later, and may provide a second power supply voltage ELVSS to the light emitting element OLED.

The light blocking patterns BML1, BML2, and BML3 may be disposed between the second data line DL2 and the power pattern EBR and may be spaced apart from each other in the second direction DR2. The above-described first lower conductive pattern LPT1 (see FIG. 5B) may correspond to one of the light blocking patterns BML1, BML2, and BML3. That is, the light blocking patterns BML1, BML2, and BML3 may be individually provided to partially overlap the semiconductor layer of the transistor (e.g., the first transistor T1) among the corresponding pixels. According to an embodiment, each of the light blocking patterns BML1, BML2, and BML3 may be connected to the source S1 of the overlapping first transistor T1 and receive a signal applied to the source S1 to form a sync structure below the semiconductor pattern.

The above-described second lower conductive pattern LPT2 (see FIG. 5B) may correspond to the other portion of the light blocking patterns BML1, BML2, and BML3. That is, a portion of each of the light blocking patterns BML1, BML2, and BML3 may correspond to the first lower conductive pattern LPT1 overlapping the transistor (e.g., the first transistor T1), and the other portion of each of the light blocking patterns BML1, BML2, and BML3 may correspond to the second lower conductive pattern LPT2 constituting the capacitor Cst. Thus, the first lower conductive pattern LPT1 and the second lower conductive pattern LPT2 may have an integrated shape. However, this is illustrated as an example, and the second lower conductive pattern LPT2 may have a configuration other than the light blocking patterns BML1, BML2, and BML3, but is not limited to any one embodiment.

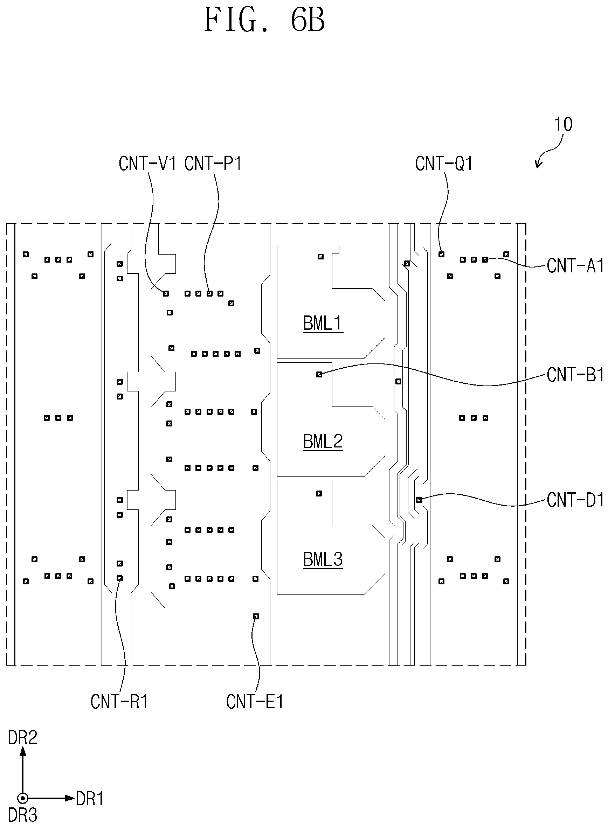

Referring to FIG. 6B, the first conductive layer MSL1 may be covered by the first insulating layer 10. FIG. 6B illustrates contact holes defined in the first insulating layer 10. The first insulating layer 10 may be disposed on the base layer BS (see FIG. 5B) to cover the first conductive layer MSL1. The plurality of contact holes passing through the first insulating layer 10 and exposing a portion of the first conductive layer MSL1 may be defined in the first insulating layer 10.

First initial contact holes CNT-R1 may expose a portion of the initial line IL. First-first additional contact holes CNT-A1 and first-second additional contact holes CNT-Q1 may expose a portion of the first line E-1. One of the first-first additional contact holes CNT-A1 and the first-second additional contact holes CNT-Q1 may correspond to a portion of the fourth contact hole CH4 (see FIG. 5B) described above. First-first power contact holes CNT-P1, first-second power contact holes CNT-V1, and a first line contact hole CNT-E1 expose a portion of the power pattern EBR.

First data contact holes CNT-D1 may expose a portion of the corresponding data line from among the first to third data lines DL1, DL2, and DL3.

First light blocking contact holes CNT-B1 may expose a portion of the corresponding light blocking pattern from among the light blocking patterns BML1, BML2, and BML3. Each of the first light blocking contact holes CNT-B1 may correspond to a portion of the above-described first contact hole CH1 (see FIG. 5B). This is illustrated as an example, and the number and positions of contact holes defined in the first insulating layer 10 may be changed in various manners, but are not limited to any one embodiment.

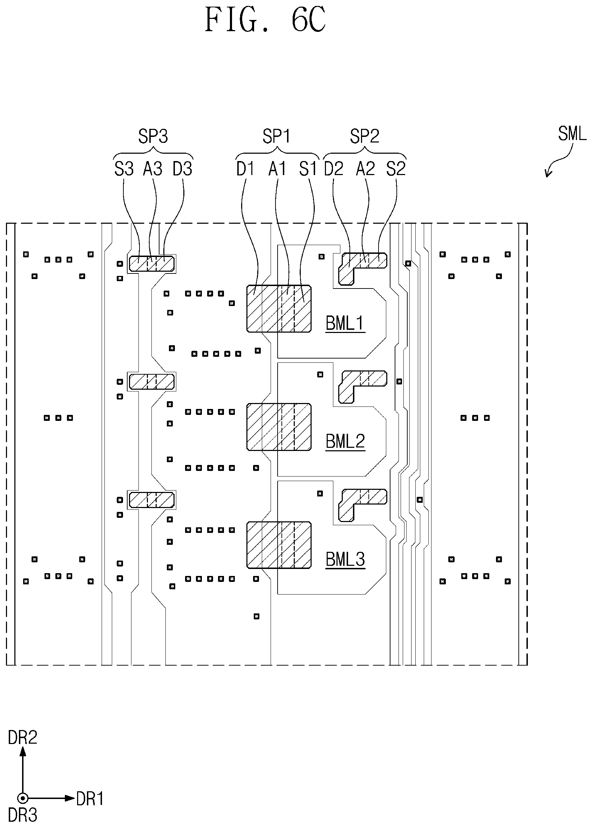

Referring to FIG. 6C, the semiconductor pattern layer SML according to an embodiment of the inventive concept may be disposed on the first insulating layer 10. The semiconductor pattern layer SML may include first to third semiconductor patterns SP1, SP2, and SP3 arranged to be spaced apart from each other on the plane.

The first semiconductor pattern SP1 may include a source S1, a drain D1, and a channel region A1 (hereinafter, referred to as a channel). The channel A1 may be disposed between the source S1 and the drain D1. The first semiconductor pattern SP1 may be provided in plurality, which are disposed to overlap the light blocking patterns BML1, BML2, and BML3, respectively.

Likewise, the second semiconductor pattern SP2 may include a source S2, a drain D2, and a channel A2. The channel A2 may be disposed between the source S2 and the drain D2. The second semiconductor pattern SP2 may be provided in plurality, which are spaced apart from each other in the second direction DR2. Each of the second semiconductor patterns SP2 may be disposed between the corresponding light blocking pattern and each of the data lines DL1, DL2, and DL3.

In addition, the third semiconductor pattern SP3 may include a source S3, a drain D3, and a channel A3. The channel A3 may be disposed between the source S3 and the drain D3. The third semiconductor pattern SP3 may be provided in plurality, which are spaced apart in the second direction DR2 and disposed between the initial line IL and the power pattern EBR.

The regions respectively included in the semiconductor patterns SP1, SP2, and SP3 may be divided into the source, the drain, and the channel after a reduction process is performed using a gate as a mask, which will be described later.

Each of the semiconductor patterns SP1, SP2, and SP3 may be provided as an oxide semiconductor pattern. For example, the oxide semiconductor may include any one of indium gallium zinc oxide (IGZO) and indium tin zinc oxide (ITZO). However, this embodiment is not limited thereto, and the semiconductor patterns may be made of amorphous silicon or polycrystalline silicon, but is not limited to any one embodiment.

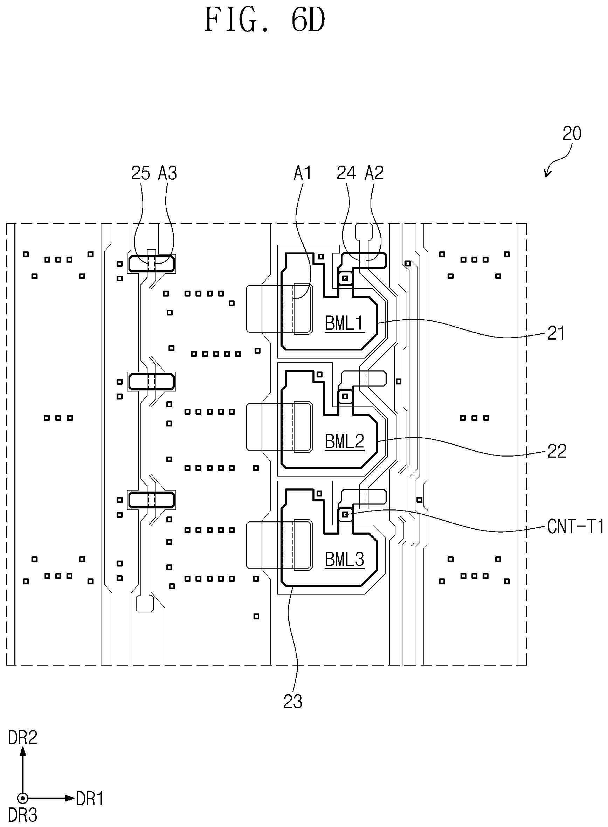

Referring to FIG. 6D, the second insulating layer 20 may be disposed on the semiconductor pattern layer SML. The second insulating layer 20 may be disposed on the first insulating layer 10 to cover at least a portion of the semiconductor pattern layer SML. The second insulating layer 20 may include a plurality of insulating patterns 21, 22, 23, 24, and 25 disposed to be spaced apart from each other on the plane. In this embodiment, the second insulating layer 20 may include first to fifth insulating patterns 21, 22, 23, 24, and 25.

The first to third insulating patterns 21, 22, and 23 may be patterns that overlap the first to third light blocking patterns BML1, BML2, and BML3, respectively. Each of the first to third insulating patterns 21, 22, and 23 may have a shape that overlaps the channel A1 of the first semiconductor pattern SP1 and exposes the source S1 and the drain D1. Specifically, the first insulating pattern 21 may overlap the first light blocking pattern BML1 and the first semiconductor pattern SP1. A portion of the first insulating pattern 21, which overlaps the channel A1 of the first semiconductor pattern SP1, may correspond to the gate insulating film 20T (see FIG. 5B), and a portion of the first insulating pattern 21, which overlaps the first light blocking pattern BML1 other than the channel A1, may corresponds to the capacitor insulating film 20C (see FIG. 5B) to function as a dielectric of the capacitor. In this embodiment, the gate insulating film 20T and the capacitor insulating film 20C are illustrated as being connected to each other to form a first insulating pattern 21 having an integrated shape, but is not limited thereto. For example, the gate insulating film 20T and the capacitor insulating film 20C may be provided as separate patterns, but are not limited to any one embodiment. Likewise, the second insulating pattern 22 may overlap the second light blocking pattern BML2 and the channel A1 of the first semiconductor pattern SP1 that overlaps the second light blocking pattern BML2. The third insulating pattern 23 may overlap the third light blocking pattern BML3 and the channel A1 of the first semiconductor pattern SP1 that overlaps the third light blocking pattern BML3.

The fourth insulating pattern 24 may be a pattern that overlaps the second semiconductor pattern SP2. In this embodiment, the fourth insulating pattern 24 may have a shape of an integrated line that overlaps all of the plurality of second semiconductor patterns SP2. The channels A2 of the second semiconductor patterns SP2 may overlap one fourth insulating pattern 24.

The fifth insulating pattern 25 may be a pattern that overlaps the third semiconductor pattern SP3. In this embodiment, the fifth insulating pattern 25 may have a shape of an integrated line that overlaps all of the plurality of third semiconductor patterns SP3. The channels A3 of the third semiconductor patterns SP3 may overlap one fifth insulating pattern 25.

A plurality of contact holes passing through the second insulating layer 20 to expose a portion of the second conductive layer MSL2 may be defined in the second insulating layer 20. For example, a first gate contact hole CNT-T1 may be defined in each of the first to third insulating patterns 21, 22, and 23. The first gate contact hole CNT-T1 may overlap a protrusion protruding from the drain D2 included in the second transistor T2.

This is illustrated as an example, and the first to fifth insulating patterns 21, 22, 23, 24, and 25 may be connected to each other. Here, the second insulating layer 20 may be provided as a single layer, and the first gate contact hole CNT-T1 may be defined in the second insulating layer 20. Alternatively, some of the first to fifth insulating patterns 21, 22, 23, 24, and 25 may be connected to each other, and some may have separated shapes, but are not limited to any one embodiment.

A predetermined contact hole may be defined in each of the first to third insulating patterns 21, 22, and 23. For example, the first gate contact hole CNT-T1 may be defined in an area of each of the first to third insulating patterns 21, 22, and 23, which overlaps the second semiconductor patterns SP2. Portions overlapping the first to third insulating patterns 21, 22, and 23 may be portions of the drains D2 of each of the second semiconductor patterns SP2, which protrude toward the first to third light blocking patterns BML1, BML2, and BML3. Thus, the first gate contact hole CNT-T1 may expose a portion of the drains D2 of each of the second semiconductor patterns SP2.

Referring to FIG. 6E, the second conductive layer MSL2 may be disposed on the second insulating layer 20. According to an embodiment of the inventive concept, the contact holes may be defined in the second insulating layer 20, and then, the conductive layer disposed on the second insulating layer 20 may be patterned to form the conductive patterns of the second conductive layer MSL2. Thereafter, the second insulating layer 20 illustrated in FIG. 6D may be patterned using the conductive patterns as a mask to include first to fifth insulating patterns 21, 22, 23, 24, and 25. That is, the first to fifth insulating patterns 21, 22, 23, 24, and 25 may be formed after the second conductive layer MSL2 is formed. However, this is merely an example, and the second conductive layer MSL2 may be formed after the first to fifth insulating patterns 21, 22, 23, 24, and 25 are formed, but is limited to an embodiment.

Thus, in the present disclosure, a shape of the second insulating layer 20 on the plane may correspond to the shapes of the conductive patterns provided in the second conductive layer MSL2 except for the contact holes defined in the second insulating layer 20. In the present disclosure, the meaning of 'corresponding to the shape' does not mean having the same area on the plane and may include an error in the process. This is illustrated as an example, and the patterning of the second insulating layer 20 may be omitted after forming the third conductive layer MSL3. Here, the second insulating layer 20 may be provided in a shape that covers all of the semiconductor pattern SP and the first insulating layer 10.

Referring again to FIG. 6E, the second conductive layer MSL2 may include a sensing pattern SS-P, a scan pattern SC-P, and first to third gate conductive patterns GML1, GML2, and GML3.

The sensing pattern SS-P may extend along the second direction DR2 to overlap the plurality of third semiconductor patterns SP3. The sensing pattern SS-P may overlap the channel A3 of each of the third semiconductor patterns SP3 and may not overlap the drain D3 and the source S3. The sensing pattern SS-P provides the gate of each of the third transistors T3 illustrated in FIG. 5A and may correspond to the gate GT illustrated in FIG. 5B.

The scan pattern SC-P may extend along the second direction DR2 to overlap a plurality of second semiconductor patterns SP2. The scan pattern SC-P may overlap the channel A2 of each of the second semiconductor patterns SP2 and may not overlap the drain D2 and the source S2. The scan pattern SC-P may provide the gate of each of the second transistors T2 illustrated in FIG. 5A.

The first to third gate conductive patterns GML1, GML2, and GML3 may be disposed to overlap the first to third light blocking patterns BML1, BML2, and BML3, respectively. The first to third gate conductive patterns GML1, GML2, and GML3 may provide capacitors together with the first to third light blocking patterns BML1, BML2, and BML3, respectively. Each of the first to third gate conductive patterns GML1, GML2, and GML3 may correspond to the upper conductive pattern UPT illustrated in FIG. 5B and provide one electrode of the capacitor Cst illustrated in FIG. 4B.

Some of the first to third gate conductive patterns GML1, GML2, and GML3 may overlap the first semiconductor patterns SP1. Each of the first to third gate conductive patterns GML1, GML2, and GML3 may overlap the channel A1 of each of the first semiconductor patterns SP1 and may not overlap the drain D1 and the source S1. A portion of the first to third gate conductive patterns GML1, GML2, and GML3, which overlaps the channel A1, may provide the gate of the first transistor T1. This may correspond to the gate electrode GT illustrated in FIG. 5B. Some of the first to third gate conductive patterns GML1, GML2, and GML3 may overlap the source S2 of each of the second semiconductor patterns SP2. Each of the first to third gate conductive patterns GML1, GML2, and GML3 may be connected to the second semiconductor pattern SP2 through the first gate contact hole CNT-T1.

According to an embodiment of the inventive concept, the reduction process of the semiconductor patterns included in each of the first to third transistors T1, T2, and T3 may be performed using the second conductive layer MSL2 as a mask. Thus, the source and the drain of each of the semiconductor patterns SP1, SP2, and SP3 may be exposed from the sensing pattern SS-P, the scan pattern SC-P, and the first to third gate conductive patterns GML1, GML2, and GML3 and thus may have greater conductivity than that of the channel. The second insulating layer 20 may be patterned after forming the second conductive layer MSL2 to provide a plurality of insulating patterns 21, 22, 23, 24, and 25. That is, the insulating patterns 21, 22, 23, 24, and 25 may be provided by being patterned using the sensing pattern SS-P, the scan pattern SC-P, and the first to third gate conductive patterns GML1, GML2, and GML3 as a mask. This is illustrated as an example, and as described above, the second insulating layer 20 may be provided as an integrated layer in which all of the insulating patterns 21, 22, 23, 24, and 25 are connected without the patterning process, but is not limited to any one embodiment.

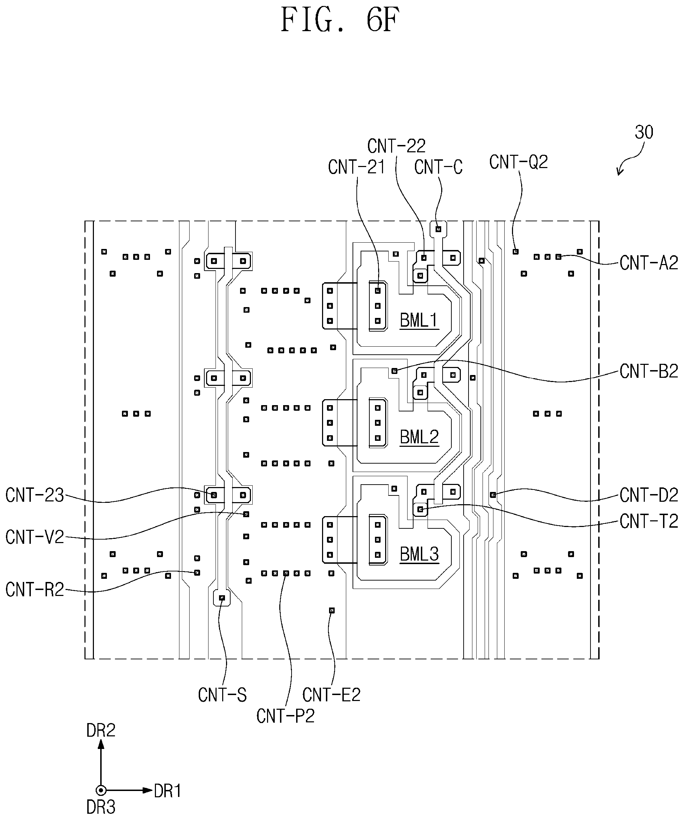

Referring to FIG. 6F, the third insulating layer 30 may be disposed on the second conductive layer MSL2. The third insulating layer 30 may cover the second conductive layer MSL2. FIG. 6F illustrates contact holes defined in the third insulating layer 30. A plurality of contact holes passing through the third insulating layer 30 to expose a portion of the third conductive layer MSL3 may be defined in the third insulating layer 30.

Second initial contact holes CNT-R2 may overlap the first initial contact holes CNT-R1 of the first insulating layer 10. The second initial contact holes CNT-R2 and the first initial contact holes CNT-R1 may expose a portion of the initial line IL.

Each of the second line contact holes CNT-E2 may overlap the first line contact hole CNT-E1 of the first insulating layer 10. The first line contact hole CNT-E1 and the second line contact hole CNT-E2 may expose a portion of the power pattern EBR.

Second first power contact holes CNT-P2 may overlap the first-first power contact holes CNT-P1. The second first power contact holes CNT-P2 and the first-first power contact holes CNT-P1 may expose a portion of the power pattern EBR. Second-second power contact holes CNT-V2 may overlap the first-second power contact holes CNT-V1. The first-second second power contact holes CNT-V1 and the second-second power contact holes CNT-V2 may expose a portion of the power pattern EBR.

A second light blocking contact hole CNT-B2 may overlap the first light blocking contact hole CNT-B1. The second light blocking contact hole CNT-B2 may expose the corresponding light blocking patterns BML1, BML2, and BML3. A contact hole defined by connecting the second light blocking contact hole CNT-B2 to the first light blocking contact hole CNT-B1 may correspond to the first contact hole CH1 (see FIG. 5B).

The second-first additional contact holes CNT-A2 and the second-second additional contact holes CNT-Q2 overlap the first line E-1. The second-first additional contact holes CNT-A2 may overlap the first-1 additional contact holes CNT-A1 of the first insulating layer 10, respectively. The second-second additional contact holes CNT-Q2 may overlap the first-second additional contact holes CNT-Q1 of the first insulating layer 10, respectively. The contact holes defined by connecting the second-first additional contact holes CNT-A2 to the first-first additional contact holes CNT-A1 or the contact holes defined by connecting the second-second additional contact holes CNT-Q2 to the first-second additional contact holes CNT-Q1 may correspond to the fourth contact hole CH4 (see FIG. 5B).

Second-first semiconductor contact holes CNT-21 may expose a portion of the source S1 and the drain D1, which are provided in the first transistor T1. The contact hole of the second-first semiconductor contact holes CNT-21, which overlaps the source S1 included in the first transistor T1, may correspond to the second contact hole CH2 (see FIG. 5B). The contact hole of the second-first semiconductor contact holes CNT-21, which overlaps the drain D1 included in the first transistor T1, may correspond to the third contact hole CH3 (see FIG. 5B).

Second second semiconductor contact holes CNT-22 may expose a portion of the source S2 and the drain D2, which are provided in the second transistor T2. Second third semiconductor contact holes CNT-23 may expose a portion of the source S3 and the drain D3, which are provided in the third transistor T3. The second gate contact hole CNT-T2 may expose a portion of each of the gate conductive patterns GML1, GML2, and GML3.

A scan contact hole CNT-C may expose a portion of the scan pattern SC-P. A sensing contact hole CNT-S may expose a portion of the sensing pattern SS-P.

Second data contact holes CNT-D2 may overlap the first data contact holes CNT-D1. Second data contact holes CNT-D2 may expose a portion of the corresponding data line from among the first to third data lines DL1, DL2, and DL3. This is illustrated as an example, and the number and positions of contact holes defined in the third insulating layer 30 may be changed in various manners, but are not limited to any one embodiment.

Referring to FIG. 6G, the third conductive layer MSL3 may be disposed on the third insulating layer 30. The third conductive layer MSL3 may include a scan line SCL, a sensing line SSL, a first power line ED, a first sub-pattern CP1, a second sub-pattern CP2, a sub-initial line IL-S, a first additional power pattern ED-S1, first to third source conductive patterns SML1, SML2, and SML3, and a second line E-2 of the second power line EL. That is, each of the above-described first conductive patterns CPT1a, CPT1b, CPT1c, and CPT1d (see FIG. 5B) may correspond to one of the scan line SCL, the sensing line SSL, the first power line ED, the first sub-pattern CP1, the second sub-pattern CP2, the sub-initial line RL-S, the first additional power pattern ED-S1, the first to third source conductive patterns SML1, SML2, and SML3, and the second line E-2.

The second line E-2 may overlap the first line E-1 to extend in the second direction DR2. The second line E-2 may be disposed in the second-first additional contact holes CNT-A2 and be connected to the first line E-1. The second line E-2 may be connected to the first line E-1 through the first-second additional contact holes CNT-Q1 and the second-second additional contact holes CNT-Q2. The second line E-2 of the second power line EL may correspond to the third connection electrode CPT1d (see FIG. 5B).

Each of the scan line SCL, the sensing line SSL, and the first power line ED may extend in the first direction DR1, and the scan line SCL, the sensing line SSL, and the first power line ED may be spaced apart from each other in the second direction DR2. The scan line SCL may be connected to the scan pattern SC-P through the scan contact hole CNT-C. For convenience of explanation, FIG. 6G illustrates a state in which the scan line SCL disposed at an upper end is connected to the scan pattern SC-P through the scan contact hole CNT-C, and the scan line SCL disposed at a lower end overlaps the scan pattern SC-P. However, the connection relationship between the scan line SCL and the scan pattern SC-P, which are disposed at the lower end may be the same as that between the scan line SCL and the scan pattern SC-P disposed at the upper end.

The sensing line SSL may be connected to the sensing pattern SS-P through the sensing contact hole CNT-S.

The first power line ED may cross the power pattern EBR on the plane. The first power line ED may be connected to the power pattern EBR through the second line contact hole CNT-E2 and the first line contact hole CNT-E1.

The first additional power pattern ED-S1 may be individually provided to each of the pixels. A portion of the first additional power pattern ED-S1, which overlaps the power pattern EBR, may be disposed in the second-first power contact holes CNT-P2 and may be connected to the power pattern EBR. The first additional power pattern ED-S1 may correspond to the above-described second connection electrode CPT1b.

In addition, a portion of the first additional power pattern ED-S1, which overlaps the first semiconductor pattern S1 may be disposed in the contact hole of the second-first semiconductor contact holes CNT-21, which overlaps the drain D1 of the first transistor T1 and may be connected to the first transistor T1.

The first to third source conductive patterns SML1, SML2, and SML3 are arranged to be spaced apart from each other in the second direction DR2. The first to third source conductive patterns SML1, SML2, and SML3 may be arranged to overlap the first to third light blocking patterns BML1, BML2, and BML3, respectively.

A portion of each of the first to third source conductive patterns SML1, SML2, and SML3 may be disposed in the first light blocking contact hole CNT-B1 and the second light blocking contact hole CNT-B2 and be connected to a corresponding light blocking pattern. The other portion of each of the first to third source conductive patterns SML1, SML2, and SML3 may be disposed in the contact hole of the second-first semiconductor contact holes CNT-21, which overlap the source S1 of the first transistor T1, and be connected to the first transistor T1. Thus, each of the first to third source conductive patterns SML1, SML2, and SML3 may correspond to the above-described first connection electrode CPT1a (see FIG. 5B), and the contact hole of the second-first semiconductor contact holes CNT-21, which overlaps the source S1 of the first transistor T1, may correspond to the second contact hole CH2 (see FIG. 5B).

The other portion of each of the first to third source conductive patterns SML1, SML2, and SML3 may extend to the drain D3 of the third transistor T3. Each of the first to third source conductive patterns SML1, SML2, and SML3 may be disposed in the contact hole of the second third semiconductor contact hole CNT-23, which overlap the drain D3, to connect the first transistor T1 to the third transistor T3.

In addition, the first to third source conductive patterns SML1, SML2, and SML3 may be disposed to overlap the first to third gate conductive patterns GML1, GML2, and GML3 (see FIG. 6E), respectively. The other portion of each of the first to third source conductive patterns SML1, SML2, and SML3 may correspond to the above-described first pattern CPT1c (see FIG. 5B). That is, the first pattern CPT1c (see FIG. 5B) may have an integrated shape connected to the second connection electrode CPT1b. However, this is illustrated as an example, and the first pattern CPT1c may be a conductive pattern other than the first to third source conductive patterns SML1, SML2, and SML3, but is not limited to any one embodiment.

The first sub-pattern CP1 may connect the second transistor T2 to a corresponding data line of the data lines DL1, DL2, and DL3. One end of the first sub-pattern CP1 may overlap the drain D2 of the second transistor T2 and be disposed in the contact hole that overlaps the drain D2 of the second transistor T2 among the second-second semiconductor contact holes CNT-22. The other end of the first sub-pattern CP1 may extend to the corresponding data line and be disposed in the first data contact hole CNT-D1 and the second data contact hole CNT-D2 so as to be connected to the corresponding data line. Thus, the second transistor T2 and the data line may be connected to each other through the first sub-pattern CP1.

One end of the second sub-pattern CP2 may overlap the source S2 of the second transistor T2 and be disposed in the contact hole that overlaps the source S2 of the second transistor T2 among the second-second semiconductor contact holes CNT-22. The other end of the second sub-pattern CP2 may overlap each of the gate conductive patterns GML1, GML2, and GML3 and may be disposed in the second gate contact hole CNT-T2. Thus, the second transistor T2 and the first transistor T1 may be connected to each other through the second sub-pattern CP2.

The sub-initial line RL-S may overlap the initial line IL. The sub-initial line RL-S may be connected to the initial line IL through the first and second initial contact holes CNT-R1 and CNT-R2.

In this embodiment, the conductive patterns provided in the third conductive layer MSL3 may be provided as a plurality of layers. For example, the third conductive layer MSL3 may be provided as two-layered metal layers, in which titanium (Ti)/copper (Cu) are laminated or may be provided three-layered metal layers, in which titanium (Ti)/aluminium (Al)/titanium (Ti) are laminated.

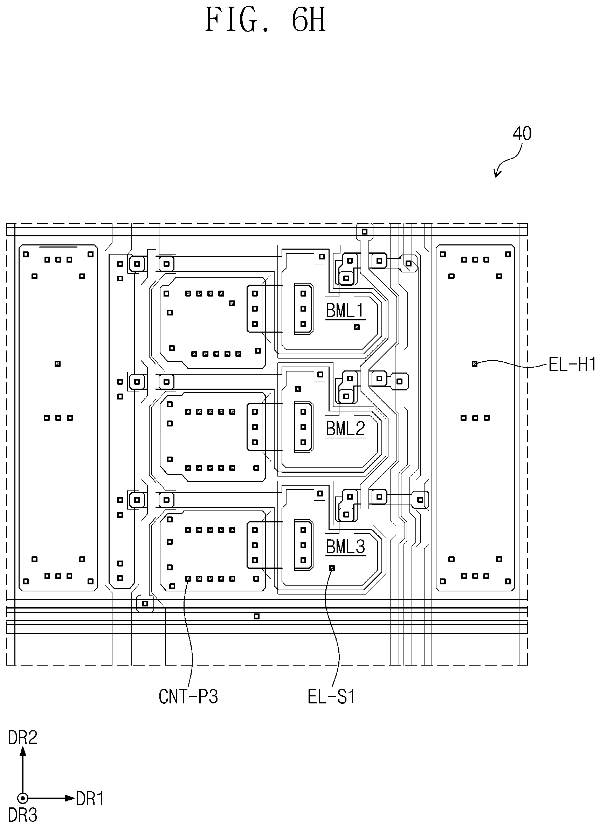

Referring to FIG. 6H, a first inorganic layer 40 may be disposed on the third conductive layer MSL3. FIG. 6H illustrates contact holes defined in the first inorganic layer 40. The first inorganic layer 40 may be disposed on the first insulating layer 30 to cover the third conductive layer MSL3. A plurality of contact holes passing through the first inorganic layer 40 to expose a portion of the fourth conductive layer MSL4 may be defined in the first inorganic layer 40.

A first via contact hole EL-H1 may expose a portion of the second line E-2. The first via contact hole EL-H1 may correspond to a portion of the sixth contact hole CH6 (see FIG. 5B) described above. A first anode contact hole EL-S1 may expose a portion of each of the source conductive patterns SML1, SML2, and SML3. The first anode contact hole EL-S1 may correspond to a portion of the above-described fifth contact hole CH5 (see FIG. 5B).

Third first power contact holes CNT-P3 may disposed to overlap the first additional power patterns ED-S1. The third first power contact holes CNT-P3 may expose a portion of the corresponding first additional power pattern ED-S1.

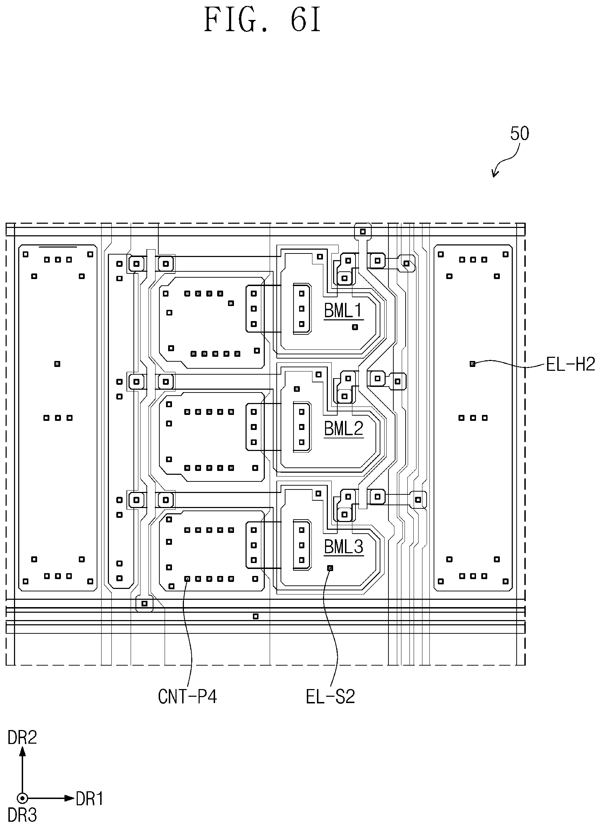

Referring to FIG. 6I, a first organic layer 50 may be disposed on the first inorganic layer 40. FIG. 6I illustrates contact holes defined in the first organic layer 50. A plurality of contact holes that pass through the first organic layer 50 to overlap the contact holes defined in the first inorganic layer 40 may be defined in the first organic layer 50.

A second via contact hole EL-H2 may overlap the first via contact hole EL-H1. An area of the second via contact hole EL-H2 may be larger than that of the first via contact hole EL-H1. The first via contact hole EL-H1 and the second via contact hole EL-H2 may expose a portion of the second line E-2 of the first power line ED. That is, the first via contact hole EL-H1 and the second via contact hole EL-H2 may be connected to each other to define the sixth contact hole CH6 (see FIG. 5B).

The second anode contact hole EL-S2 may overlap the first anode contact hole EL-S1. The first anode contact hole EL-S1 and the second anode contact hole EL-S2 may expose a portion of each of the source conductive patterns SML1, SML2, and SML3. The second anode contact hole EL-S2 may be connected to the first anode contact hole EL-S1 to define the above-described fifth contact hole CH5 (see FIG. 5B).

Fourth-1 power contact holes CNT-P4 may overlap the third-1 power contact holes CNT-P3. The fourth-1 power contact holes CNT-P4 may be connected to the third first power contact holes CNT-P3 to expose the corresponding first additional power patterns ED-S1.

According to an embodiment of the inventive concept, the first inorganic layer 40 may be omitted. Thus, the first inorganic layer 40 and the first organic layer 50 may be provided as one insulating layer, and the above-described contact holes defined in the first inorganic layer 40 and the above-described contact holes defined in the first organic layer 50 may be defined in the one insulating layer, but are not limited to any one embodiment.

Referring to FIG. 6J, the fourth conductive layer MSL4 may be disposed on the first organic layer 50. The fourth conductive layer MSL4 may include first to third additional conductive patterns MP1, MP2, and MP3, second additional power patterns ED-S2, and a third line E-3.

The first to third additional conductive patterns MP1, MP2, and MP3 may be disposed to be spaced apart from each other in the second direction DR2. The first to third additional conductive patterns MP1, MP2, and MP3 may be disposed to overlap the first to third source conductive patterns SML1, SML2, and SML3, respectively.

Each of the first to third additional conductive patterns MP1, MP2, and MP3 may overlap the second anode contact hole EL-S2. Each of the first to third additional conductive patterns MP1, MP2, MP3 may be connected to the corresponding source conductive pattern of the first to third source conductive patterns SML1, SML2, and SML3 through the first anode contact hole EL-S1 and second anode contact hole EL-S2. Thus, each of the first to third additional conductive patterns MP1, MP2, and MP3 may correspond to the fourth connection electrode CPT2a described above.

The second additional power patterns ED-S2 may be arranged to be spaced apart along the second direction DR2. The second additional power patterns ED-S2 may be arranged to overlap the first additional power patterns ED-S1. Each of the second additional power patterns ED-S2 may be connected to the first additional power patterns ED-S1 through the fourth-1 power contact holes CNT-P4 and the third first power contact holes CNT-P3.

The third line E-3 may have a bar shape having a length extending in the second direction DR2, but is not limited thereto. The third line E-3 may be arranged to overlap the second line E-2. The third line E-3 may be connected to the second line E-2 through the second via contact hole EL-H2 and the first via contact hole EL-H1. Thus, the third line E-3 may correspond to the above-described fifth connection electrode CPT2c.

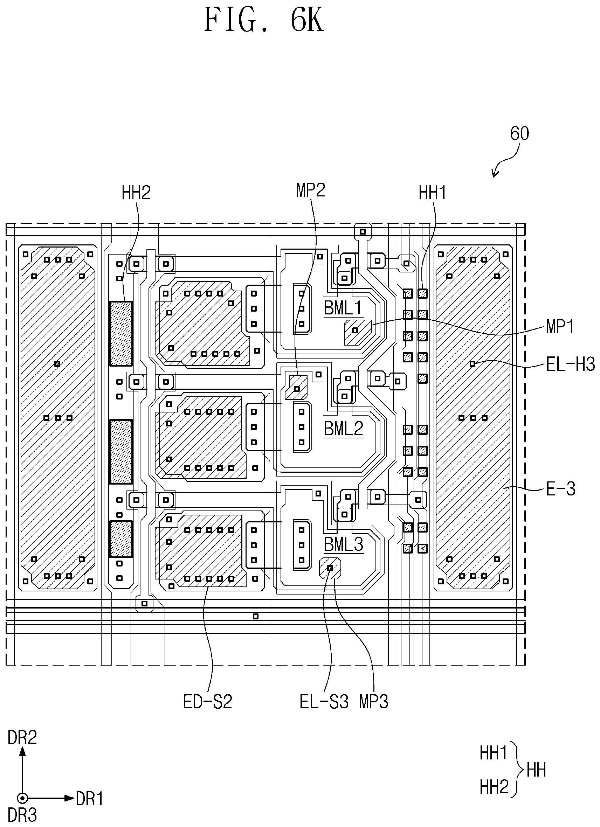

Referring to FIG. 6K, a second inorganic layer 60 may be disposed on the first organic layer 50. The second inorganic layer 60 may cover the fourth conductive layer MSL4. Specifically, the second inorganic layer 60 may cover each of the plurality of conductive patterns MP1, MP2, MP3, E-3, and ED-S constituting the fourth conductive layer MSL4. FIG. 6K illustrates contact holes EL-S3 and EL-H3 and openings HH defined in the second inorganic layer 60.

The contact holes EL-S3 and EL-H3 may pass through the second inorganic layer 60 to expose the fourth conductive layer MSL4. Specifically, the third anode contact hole EL-S3 may overlap a corresponding conductive pattern of the first to third additional conductive patterns MP1, MP2, and MP3. The third anode contact hole EL-S3 may expose a portion of a corresponding conductive pattern of the first to third additional conductive patterns MP1, MP2, and MP3. The third anode contact hole EL-S3 may correspond to a portion of the above-described seventh contact hole CH7 (see FIG. 5B). The third via contact hole EL-H3 may overlap the third line E-3. The third via contact hole EL-H3 may expose a portion of the third line E-3. The third via contact hole EL-H3 may correspond to a portion of the above-described eighth contact hole CH8 (see FIG. 5B).

The openings HH may pass through the second inorganic layer 60 to expose the first organic layer 50. The openings HH may be defined to be spaced apart from the contact holes EL-S3 and EL-H3 on the plane. In addition, the openings HH may be defined in areas that do not overlap on the plane together with the plurality of conductive patterns MP1, MP2, MP3, E-3, and ED-S constituting the fourth conductive layer MSL4. In this embodiment, the openings HH may include a first opening HH1 and a second opening HH2.

The first opening HH1 may be provided in plurality and disposed in an area between each of the additional conductive patterns MP1, MP2, and MP3 of the fourth conductive layer MSL4 and the third line E-3. The second openings HH2 may be provided in plurality and disposed in an area between each of the second additional power patterns ED-S2 and the third line E-3. The first opening HH1 is illustrated as having an area less than that of the second opening HH2. However, this is illustrated as an example, and the first opening HH1 may have an area equal to or greater than that of the second opening HH2. In addition, the number of first openings HH1 or second openings HH2 may be changed in various manners.

In an embodiment of the inventive concept, since the opening HH including the first opening HH1 and the second opening HH2 is defined in the second inorganic layer 60, a gas or moisture that may be generated from the organic layer 50 may be smoothly discharged. Thus, lifting or peeling of the second inorganic layer 60 may be prevented, and the process reliability of the display panel may be improved. As the area occupied by the opening HH in the second inorganic layer 60 increases, the gas may be easily discharged from the organic layer 50. However, as the area occupied by the opening HH in the second inorganic layer 60 increases, restrictions in arrangement of the conductive patterns or the elements constituting the pixel driving circuit may affect a pixel design. According to an embodiment of the inventive concept, a ratio occupied by the opening HH in the layer in which the opening HH is defined may be designed to be about 30% or less based on the display area DA. Specifically, a planar area of the entire opening HH relative to a planar area of the second inorganic layer 60 within the display area DA may be about 30% or less. Thus, the reliability of the display panel may be improved, and thus, a high-resolution display panel may be designed stably.

If the opening HH passes through the second inorganic layer 60 to expose the first organic layer 50 and does not overlap the conductive patterns constituting the fourth conductive layer MSL4 on the plane, the opening may have a single shape or various planar shapes such as circular, oval, or irregular shapes, but is not limited to any one embodiment. In addition, the opening HH may be defined at various positions as long as it does not overlap with the conductive patterns constituting the fourth conductive layer MSL4 on the plane, but is not limited to any one embodiment.

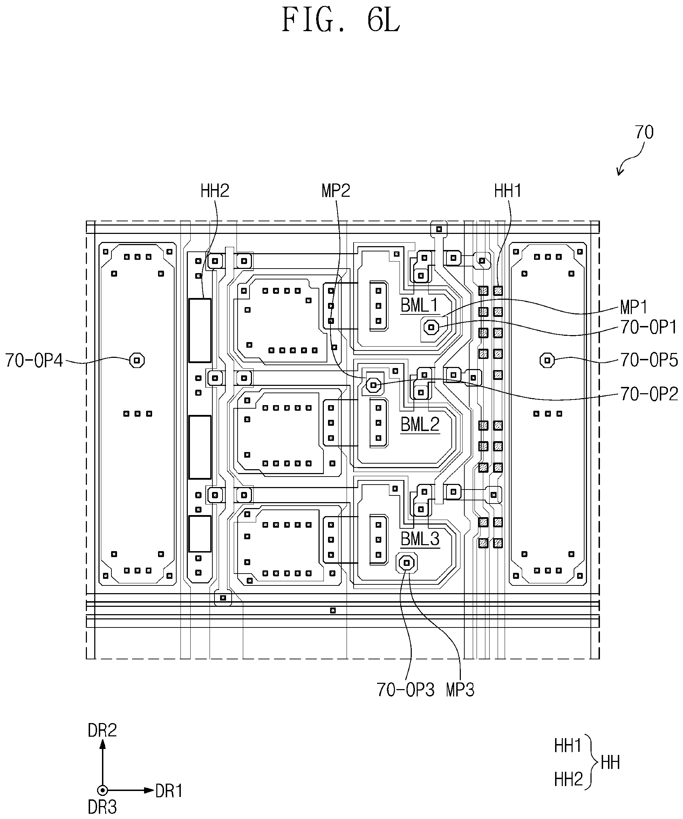

Referring to FIG. 6L, the second organic layer 70 may be disposed on the second inorganic layer 60. The second organic layer 70 may cover the second inorganic layer 60. FIG. 6L illustrates contact holes defined in the second organic layer 70.

Specifically, first to third connection contact holes 70-OP1, 70-OP2, and 70-OP3 may be defined to overlap the first to third additional conductive patterns MP1, MP2, and MP3. In addition, each of the first to third connection contact holes 70-OP1, 70-OP2, and 70-OP3 may overlap the third anode contact hole EL-S3. The first to third connection contact holes 70-OP1, 70-OP2, and 70-OP3 may be connected to the third anode contact hole EL-S3 to expose the first to third additional conductive patterns MP1, MP2, and MP3, respectively. Each of the first to third connection contact holes 70-OP1, 70-OP2, and 70-OP3 may be connected to the third anode contact hole EL-S3 to define the above-described seventh contact hole CH7 (see FIG. 5B).

The fourth connection contact hole 70-OP4 may be defined to overlap the third line E-3. In addition, the fourth connection contact hole 70-OP4 may overlap the third via contact hole EL-H3. The fourth connection contact hole 70-OP4 may be connected to the third via contact hole EL-H3 to expose the third line E-3. The fourth connection contact hole 70-OP4 may be connected to the third via contact hole EL-H3 to define the above-described eighth contact hole CH8 (see FIG. 5B).

The second organic layer 70 may overlap the openings HH on the plane. The second organic layer 70 may be in contact with the first organic layer 50 exposed through the openings HH. That is, the contact holes EL-S3 and EL-H3 passing through the first inorganic layer 60 may be exposed by the contact holes 70-OP1, 70-OP2, 70-OP3, and 70-OP4 passing through the second organic layer 70, and the openings HH passing through the first inorganic layer 60 may be filled with the second organic layer 70.

Referring to FIG. 6M, a pixel electrode layer AEL may be disposed on the second organic layer 70. FIG. 6M illustrates first electrodes AE1, AE2, and AE3 and an auxiliary electrode AXE included in the light emitting element OLED of each pixel. The first electrodes AE1, AE2, and AE3 and the auxiliary electrode AXE may be disposed on the second organic layer 70 so as to be spaced apart from each other.

The first electrodes AE1, AE2, and AE3 may be disposed to overlap the first to third connection contact holes 70-OP1, 70-OP2, and 70-OP3. The first electrodes AE1, AE2, and AE3 may be connected to the first to third additional conductive patterns MP1, MP2, and MP3, which are exposed through the first to third connection contact holes 70-OP1, 70-OP2, and 70-OP3 and the corresponding third anode contact hole EL-S3, respectively.

The first electrodes AE1, AE2, and AE3 included in each of the pixels providing different light may have areas different from each other. For example, an area of the first electrode AE2 provided in the pixel providing second color light may be less than that of the first electrode AE1 provided in the pixel providing first color light and may be greater than that of the first electrode AE3 provided in the pixel providing third color light. However, this embodiment is not limited thereto, and the areas of the first electrodes AE1, AE2, and AE3 may be the same or may have a difference from those described above. A color of light provided depending on the area of the first electrodes AE1, AE2, and AE3 may vary depending on the quality of the pixel, but is not limited to any one embodiment.

The auxiliary electrode AXE may overlap the fourth connection contact hole 70-OP4. The auxiliary electrode AXE may be connected to the third line E-3 through the fourth connection contact hole 70-OP4 and the third via contact hole EL-H3. Thus, the auxiliary electrode AXE may be connected to the second power line EL (see FIG. 4B) through the third line E-3 to receive the second voltage ELVSS (see FIG. 4B).

In an embodiment of the inventive concept, the pixel electrode layer AEL may further include an additional conductive pattern spaced apart from the first electrodes AE1, AE2, and AE3 and the auxiliary electrode AXE. Alternatively, in the pixel electrode layer AEL, the auxiliary electrode AXE may be omitted. The display panel according to an embodiment of the inventive concept may include the pixel electrode layer AEL having various structures, and is not limited to any one embodiment.

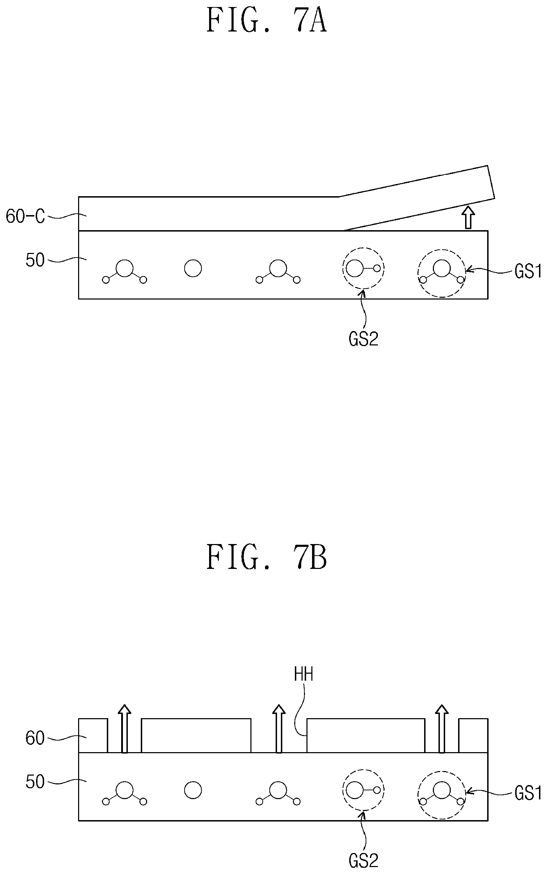

FIG. 7A is a cross-sectional view illustrating a portion of a display panel according to a comparative example of the inventive concept. FIG. 7B is a cross-sectional view illustrating a portion of a display panel according to an embodiment of the inventive concept. FIG. 7B illustrates the first organic layer 50 and the second inorganic layer 60, and FIG. 7A illustrates a laminated structures 50 and 60-C on the area corresponding to FIG. 7B according to the comparative example. Hereinafter, the present disclosure will be described with reference to FIGS. 7A and 7B. The same reference numeral may be given to components that are the same as those of FIGS. 1 to 6M, and their detailed descriptions will be omitted.

Referring to FIGS. 7A and 7B, the comparative example may include an organic layer 50 and an inorganic layer 60-C disposed on the organic layer 50. The organic layer 50 may correspond to the first organic layer 50 according to an embodiment of the inventive concept. The inorganic layer 60-C may have a structure that corresponds to the second inorganic layer 60 according to an embodiment of the inventive concept, but does not have an opening HH.

Referring to FIG. 7A, in the comparative example, when forming the organic layer 50, moisture or gas GS1 and GS2 (hereinafter, referred to as gases) may be generated within the organic layer 50. The gases GS1 and GS2 are also continuously generated during the process. Some of the gases GS1 and GS2 existing in the organic layer 50 may be escaped to the outside of the organic layer 50. Here, lifting or cracks may occur in the inorganic layer 60-C covering the organic layer 50 due to the gases GS1 and GS2. The relatively hard (brittle) inorganic layer 60-C may be damaged due to the lifting or cracks.

Referring to FIG. 7B, in an embodiment of the inventive concept, a predetermined opening HH may be defined in the second inorganic layer 60. The opening HH may pass through the second inorganic layer 60 to expose a top surface of the first organic layer 50. The gases GS1 and GS2 existing in the first organic layer 50 may be escaped to the outside of the first organic layer 50 through the opening HH. Thus, the gases GS1 and GS2 may smoothly escaped from the first organic layer 50 without the second inorganic layer 60 is lifted or damaged. Although not shown, the gases GS1 and GS2 escaped through the opening HH may be transferred to the second organic layer 70 (see FIG. 5B) that is in contact with the first organic layer 50 through the opening HH and then may remain in the second organic layer 70 or be escaped to the outside through the second organic layer 70.

According to an embodiment of the inventive concept, the predetermined opening HH may be defined in the inorganic layer 60 covering the top surface of the organic layer 50 to provide a discharge path for the gas or moisture that may be generated from the organic layer 50. Thus, the gas existing in the organic layer 50 may be escape smoothly to improve process reliability of the display panel.

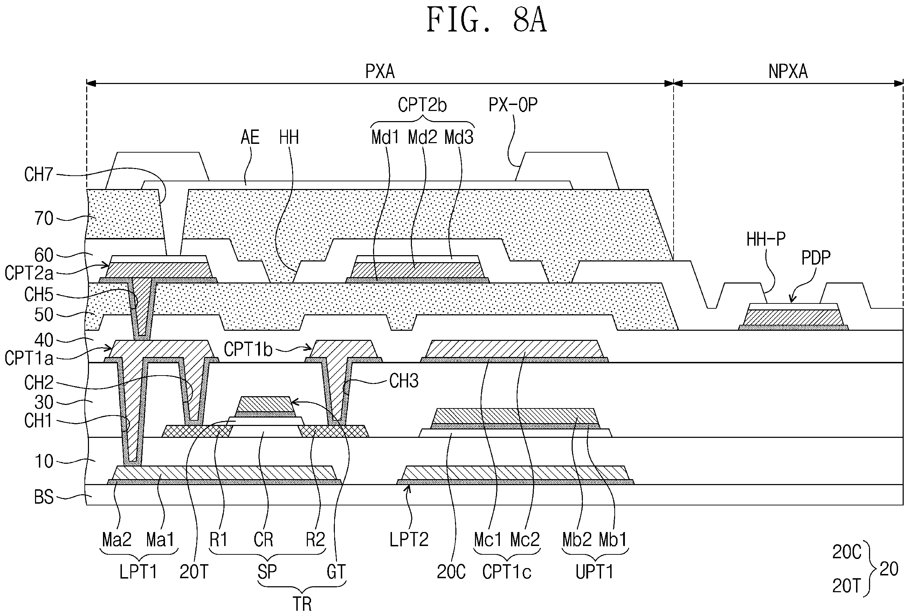

FIGS. 8A to 8C are cross-sectional views of the display panel according to an embodiment of the inventive concept. FIGS. 8A to 8C illustrate the emission area PXA and the non-emission area NPXA together. Hereinafter, an embodiment of the inventive concept will be described with reference to FIGS. 8A to 8C. Hereinafter, the same reference numeral may be given to components that are the same as those of FIGS. 1 to 7B, and their detailed descriptions will be omitted.

Referring to FIGS. 8A to 8C, the display panel may include pads PDP, PDP-A, and PDP-B disposed in the non-emission area NPXA. The pads PDP, PDP-A, and PDP-B may be portions electrically connected to an external circuit board.

Referring to FIG. 8A, the pad PDP may be formed simultaneously with the second conductive patterns CPT2a and CPT2b. That is, the pad PDP may have the same layer structure as each of the second conductive patterns CPT2a and CPT2b. In this embodiment, the pad PDP may have a laminated structure including a first sub-layer Md1, a second sub-layer Md2, and a third sub-layer Md3. According to an embodiment of the inventive concept, the pad PDP may be formed at the same time as the second conductive patterns CPT2a and CPT2b to reduce process costs and simplify the process without adding a separate process for forming the pad PDP.

The pad PDP may be disposed on the first inorganic layer 40. The first organic layer 50 may be disposed within the emission area PXA and may not extend to the non-emission area NPXA. The second inorganic layer 60 may be disposed to overlap both the emitting area PXA and the non-emission area NPXA. Thus, the pad PDP may be disposed between the first inorganic layer 40 and the second inorganic layer 50 on the non-emission area NPXA.

A pad-opening HH-P exposing at least a portion of the pad PDP may be defined in the second inorganic layer 50. The pad PDP may be exposed to the outside through the pad-opening HH-P and be easily electrically connected to the external circuit board. When the external circuit board and the display panel are connected, a lead of the external circuit board may be disposed in the pad-opening HH-P, or a conductive connection member may be filled.

According to an embodiment of the inventive concept, the pad-opening HH-P may be formed simultaneously with the opening HH of the second inorganic layer 50. Since the pad-opening HH-P and the opening HH are simultaneously formed through one process, an additional process for forming the opening HH becomes unnecessary. Thus, a passage through which a gas generated from the first organic layer 50 is removed may be easily formed without adding the separate process to simplify the process, reduce the process costs, and improve the process reliability.

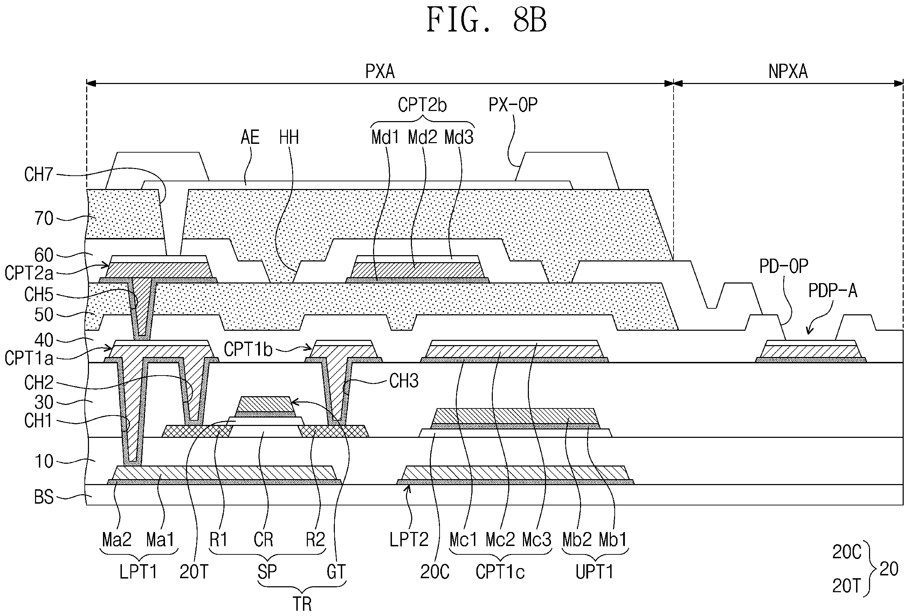

Alternatively, as illustrated in FIG. 8B, the pad PDP-A may be formed simultaneously with the first conductive patterns CPT1a, CPT1b, and CPT1c. That is, the pad PDP-A may have the same layer structure as the first conductive patterns CPT1a, CPT1b, and CPT1c. That is, in this embodiment, the pad PDP-A may have a laminated structure including a first sub-layer Mc1, a second sub-layer Mc2, and a third sub-layer Mc3. According to an embodiment of the inventive concept, the pad PDP-A may be formed at the same time as the first conductive patterns CPT1a, CPT1b, and CPT1c to reduce the process costs and simplify the process without adding a separate process for forming the pad PDP-A.

The pad PDP-A may be disposed on the third insulating layer 30. The first organic layer 50 and the second organic layer 70 may not extend to the non-emission area NPXA. The first inorganic layer 40 and the second inorganic layer 60 may be disposed to overlap both the emitting area PXA and the non-emission area NPXA. Thus, the pad PDP-A may be disposed between the third insulating layer 30 and the first inorganic layer 40 on the non-emission area NPXA.

The pad-opening PD-OP exposing at least a portion of the pad PDP-A may be provided to pass through the first inorganic layer 40 and expose a top surface of the pad PDP-A. The second inorganic layer 60 may expose at least a portion of the pad PDP-A and may not extend to the pad-opening PD-OP. That is, the second inorganic layer 60 may not overlap the pad-opening PD-OP on the plane.

According to an embodiment of the inventive concept, since the pad PDP-A is formed simultaneously with the first conductive patterns CPT1a, CPT1b, and CPT1c, electrical inspection to the panel DP may be performed when the first conductive patterns CPT1a, CPT1b, and CPT1c are formed. In addition, repairs for the display panel DP may be performed before the second conductive patterns CPT2a and CPT2b are formed, and thus, repairs for elements obscured by the second conductive patterns CPT2a and CPT2b formed later may be easily accomplished.

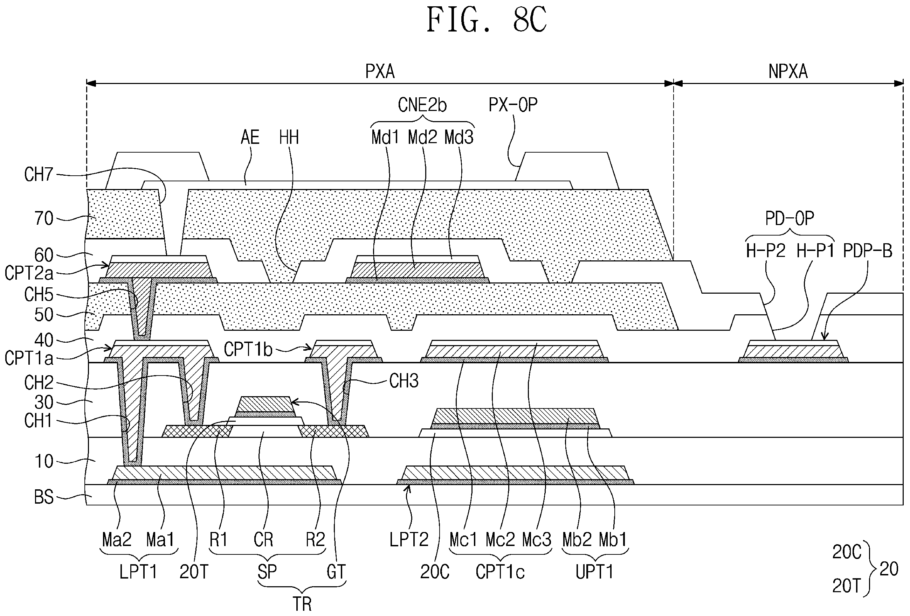

Alternatively, as illustrated in FIG. 8C, the pad-opening PD-OP may be defined by passing through the first inorganic layer 40 and the second inorganic layer 60. That is, the pad-opening PD-OP may be connected to the first opening H-P1 passing through the first inorganic layer 40 and the second opening H-P2 passing through the second inorganic layer 60.

The first opening H-P1 and the second opening H-P2 may be formed continuously. According to an embodiment of the inventive concept, the pad PDP-B may be covered by the first inorganic layer 40 while the first inorganic layer 40 is patterned. That is, in the process of forming the fifth contact hole CH5, the pad PDP-B may be covered and protected by the first inorganic layer 40. Thus, the pad PDP-B may be prevented from being damaged while the first inorganic layer 40 is patterned.

When forming the opening HH of the second inorganic layer 60, the first opening H-P1 may be formed simultaneously. After the first inorganic layer 40 and the second inorganic layer 60 extend to the non-emission area NPXA, the first inorganic layer 40 disposed below may also be continuously patterned to define the second opening H- P2. That is, even after the opening HH of the second inorganic layer 60 is formed, an etching process may continue to define the second opening H-P2 in the first inorganic layer 40. Thus, a thickness of the third sub-layer Mc3 constituting the pad PDP-B may be greater than that of the third sub-layer Md3 of the second conductive patterns CPT2a and CPT2b disposed on the emission area PXA. Even if the third sub-layer Md3 of the second conductive patterns CPT2a and CPT2b disposed in the emission area PXA is exposed from the second inorganic layer 60, since the first inorganic layer 40 is additionally etched, the third sub-layer Md3 may be exposed to the etching process until the second opening H-P2 is formed. Thus, a portion of the third sub-layer Md3 of the second conductive patterns CPT2a and CPT2b may be damaged.

According to an embodiment of the inventive concept, the pad-opening PD-OP and the opening HH may be formed through one process, and thus, a passage through which the gas generated from the first organic layer 50 is removed without adding a separate process may be easily formed. In addition, even if a position of the pad PDP-A is changed, the pad-opening PD-OP may be easily formed without changing or adding a process. This is merely an example, and the pad-openings HH-P and PD-OP according to an embodiment of the inventive concept may be formed through a process separated from the process of forming the opening HH, but is not limited to any one embodiment.

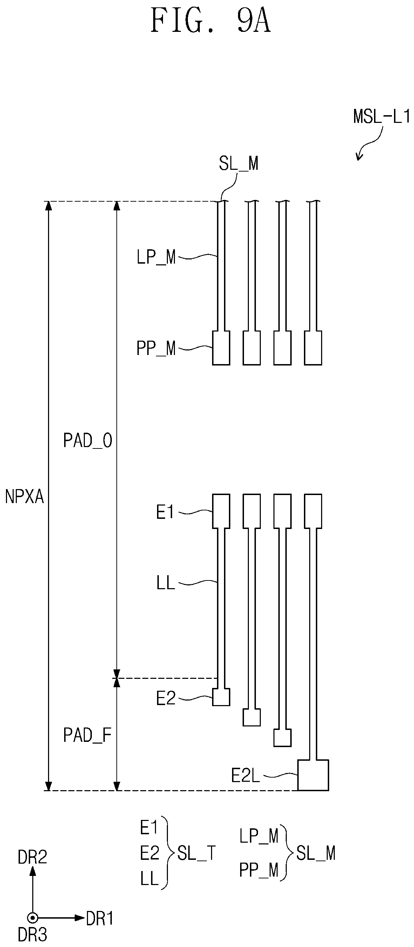

FIGS. 9A to 9D are plan views illustrating a partial area of the display panel of the display panel according to an embodiment of the inventive concept. In FIGS. 9A to 9D, some components are omitted for convenience of description. Hereinafter, the inventive concept will be described with reference to FIGS. 9A to 9E.

As illustrated in FIG. 9A, the non-emission area NPXA may include a connection area PAD_O and an inspection area PAD_F. The connection area PAD_O may be an area relatively adjacent to the emission area PXA (see FIG. 8A), and the inspection area PAD_F may be an area relatively closer to the edge of the display panel.

The first conductive layer MSL-L1 may include a plurality of main signal lines SL_M and a plurality of sub-signal lines SL_T. In this embodiment, the first conductive layer MSL-L1 may be a layer formed simultaneously with the lower conductive patterns LPT1, LPT2, and LPT3 illustrated in FIG. 5B and correspond to the first conductive layer MSL1 illustrated in FIG. 6A.

The plurality of main signal lines SL_M and the sub-signal lines SL_T may be disposed on the connection area PAD_O. The main signal lines SL_M may be lines extending by being connected to the pixels arranged on the display area or the gate driving circuit. Each of the main signal lines SL_M may include a line part LP_M and a pad part PP_M. The pad part PP_M may be defined at an end of the line part.

The pad part PP_M may be a portion to which other components are connected. A width of the pad part PP_M in the first direction may be relatively greater than that of the line part LP_M in the first direction. Thus, a contact area with other components may increase, and connection reliability may be improved. However, this is illustrated as an example, and the pad part PP_M and the line part LP_M may have the same width, but are not limited to any one embodiment.

The pad part PP_M and the line part LP_M may have an integrated shape connected to each other. That is, the pad part and the line part may be formed by being patterned simultaneously through one mask. However, this is illustrated as an example, and the pad part PP_M and the line part LP_M may be provided to be spaced apart from each other, but may be connected to each other through a separate bridge pattern, may be formed on different layers or at different times through another process, but is not limited to any one embodiment.

The sub-signal lines SL_T may be disposed to be spaced apart from the main signal lines SL_M in the second direction DR2. The sub-signal lines SL_T may be disposed across the connection area PAD_O and the inspection area PAD_F. Each of the sub-signal lines SL_T may include a line part LL, a first end E1, and a second end E2. The line part LL may extend in the second direction DR2. The first end E1 may be disposed at one side of the line part LL facing the pad part PP_M. The first end E1 may be disposed on the pad area PAD_O.

The second end E2 may be disposed on the other side of the pad part PP_M facing an edge of the panel. The second end E2 may be disposed on the inspection area PAD_F.

The first end E1 and the second end E2 may be portions to which other components are connected. A width of each of the first end E1 and the second end E2 in the first direction DR1 may be greater than that of the line part LL in the first direction DR1. Thus, a contact area with other components may increase, and connection reliability may be improved. However, this is illustrated as an example, and the first end E1 and the second end E2 may have the same width as the line part LL, but is not limited to any one embodiment.

Some of the sub-signal lines SL_T may include a second end E2L having a relatively large area. The second end E2L having the large area may be disposed closest to the edge of the display panel among the second ends. Hereinafter, since the large-area second end E2L substantially corresponds to the remaining second end E2 except for the large area, duplicated descriptions will be omitted below.

The line part LL, the first end E1, and the second ends E2 and E2L may have an integrated shape connected to each other. That is, the line part LL, the first end E1, and the second end E2 may be formed by being patterned simultaneously through one mask. However, this is illustrated as an example, and the line part LL, the first end E1, and the second end E2 may be provided to be spaced apart from each other, but may be connected to each other through a separate bridge pattern, may be formed on different layers or at different times through another process, but is not limited to any one embodiment.

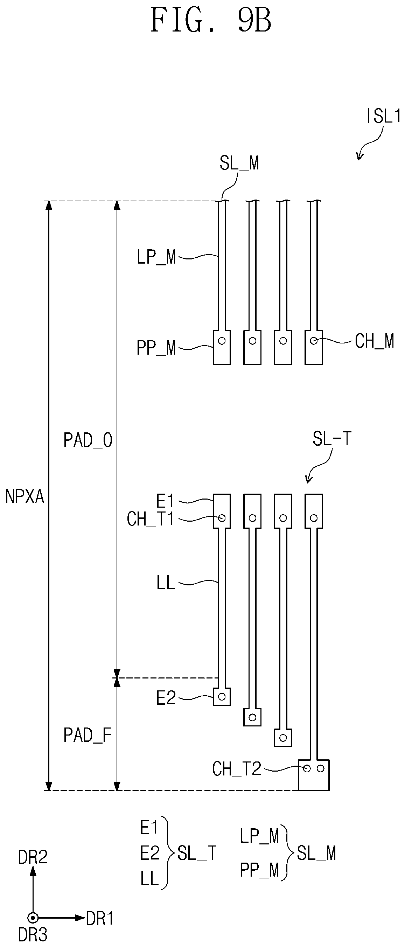

Referring to FIG. 9B, a first insulating layer ISL1 may be disposed on the first conductive layer MSL-L. FIG. 9B illustrates a plurality of contact holes CH_M, CH_T1, and CH_T2 defined in the first insulating layer ISL1. The first insulating layer ISL1 may correspond to the third insulating layer 30 (see FIGS. 5B and 6F) described above. Thus, the contact holes CH_M, CH_T1, and CH_T2 may be formed simultaneously with the contact holes illustrated in FIG. 6F, but are not limited thereto.

The first main contact hole CH_M may be defined to overlap the pad part PP_M. The first main contact hole CH_M may expose at least a portion of the pad part PP_M.

The first sub-contact hole CH_T1 may be defined to overlap the first end E1. The first sub-contact hole CH_T1 may expose at least a portion of the first end E1.

The second sub-contact hole CH_T2 may be defined to overlap the second ends E2 and E2L. The second sub-contact hole CH_T2 may expose at least a portion of the second ends E2 and E2L. The second sub-contact hole CH_T2 may be provided in plurality to correspond to the large area of the second end E2L.

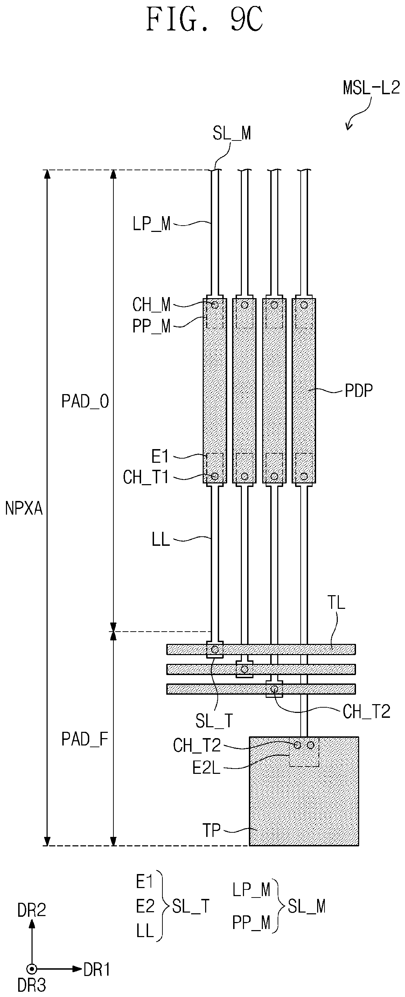

Referring to FIG. 9C, a second conductive layer MSL-L2 may be disposed on the first insulating layer ISL1. The second conductive layer MSL-L2 may be formed simultaneously with the first conductive patterns CPT1a, CPT1b, CPT1c, and CPT1d of FIG. 5B. The second conductive layer MSL-L2 may correspond to the third conductive layer MSL3 illustrated in FIG. 6G. The second conductive layer MSL-L2 may include a pad PDP, a sub-line TL, and a sub-pad TP.

The pad PDP may be provided in plurality, which are arranged to be spaced apart from each other in the first direction DR1. Each pad PDP may connect the main signal line SL_M to the sub-signal line SL_T, which are spaced apart from each other in the second direction DR2. One side of the pad PDP may overlap the pad part PP_M and be connected to the pad part PP_M through the first main contact hole CH_M. The other side of the pad PDP may overlap the first end E1 and be connected to the first end E1 through the first sub-contact hole CH_T1.

The sub-line TL may extend in the first direction DR1. The sub-line TL may be provided in plurality. The plurality of sub-lines TL may be arranged to be spaced apart from each other in the second direction DR2. Each sub-line TL may overlap each second end E2. Each sub-line TL may be connected to the corresponding second end E2 through the second sub-contact hole CH_T2.

The sub-pad TP may be disposed to overlap the large area of the second end E2L. The sub-pad TP may be provided with an area greater than that of the second end E2L. The sub-pad TP may be connected to the sub-signal line SL_T through a plurality of second sub-contact holes overlapping the large second end E2L.

According to an embodiment of the inventive concept, when forming the third conductive layer MSL3, electrical connection between the sub-pad TP, the sub-line TL, and the main signal lines SL_M may be already implemented. Thus, before the formation of the first inorganic layer 40 (see FIGS. 5B and 6H), which is performed later, electrical inspection for the pixels connected to the signal lines SL_M may be performed through the sub-pad TP or sub-line TL. In addition, even if defects occur through the electrical inspection, immediate repair may be easily performed. Therefore, according to an embodiment of the inventive concept, the electrical inspection of the display panel during the process may be easily performed to improve the electrical reliability of the display panel and improving the process reliability.

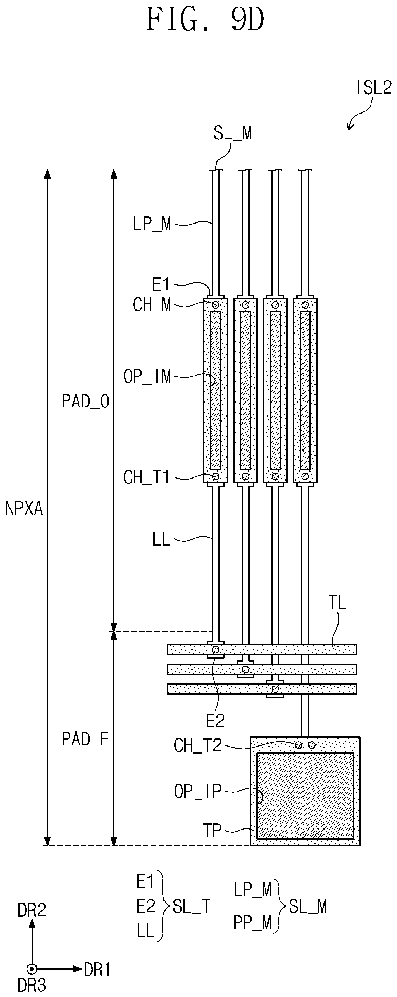

Referring to FIG. 9D, a second insulating layer ISL2 may be disposed on the second conductive layer MSL-L2. The second insulating layer ISL2 may correspond to the second inorganic layer 60 (see FIG. 5B) illustrated in FIG. 5B. FIG. 9D illustrates openings OP_IM and OP_IP defined in the second insulating layer ISL2.

The pad-opening OP_IM may be defined to overlap the pad PDP. The pad-opening OP_IM may expose at least a portion of the pad PDP. The pad-opening OP_IM may correspond to the pad-opening HH-P illustrated in FIG. 8A. That is, the pad PDP and the external circuit board may be electrically connected through the pad-opening OP_IM.

The sub-opening OP_IP may be defined to overlap the sub-pad TP. The sub-opening OP_IP may expose at least a portion of the sub-pad TP. The sub-opening OP_IP may be an area on which the sub-pad TP and an external inspection device are electrically connected. According to an embodiment of the inventive concept, the sub-opening OP_IP having a relatively large area compared to the pad-opening OP_IM may be provided, a tip part of the inspection device, etc. may be easily connected to the sub-pad TP.

The sub-opening OP_IP may be formed simultaneously with the pad-opening OP_IM. In addition, the sub-opening OP_IP and the pad-opening OP_IM may be formed at the same time as the above-described opening HH (see FIG. 5B) by being defined in the second inorganic layer 60. According to an embodiment of the inventive concept, the process may be simplified, and the process cost may be reduced by simultaneously forming the inspection pad, the connection pad, and the hole for discharging the gas.

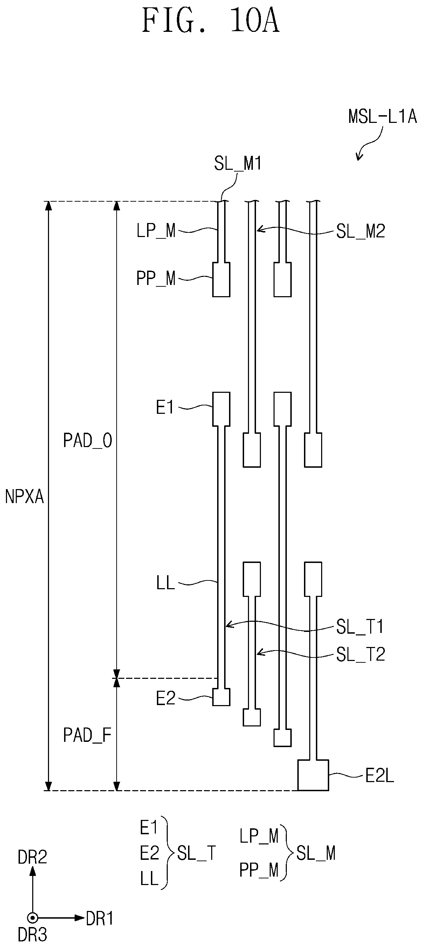

FIGS. 10A to 10F are plan views illustrating a partial area of the display panel of the display panel according to an embodiment of the inventive concept. FIGS. 10A to 10F illustrate the same area as FIGS. 9A to 9D, and some components are omitted for ease of explanation. Hereinafter, an embodiment of the inventive concept will be described with reference to FIGS. 10A to 10F.

Referring to FIG. 10A, the first conductive layer MSL-L1A may include main signal lines SL_MA and sub-signal lines SL_TA. In this embodiment, the first conductive layer MSL-L1A may be a layer formed simultaneously with the lower conductive patterns LPT1, LPT2, and LPT3 illustrated in FIG. 5B and correspond to the first conductive layer MSL-L1A illustrated in FIG. 6A. The main signal lines SL_MA may include a first signal line SL_M1 and a second signal line SL_M2. Each of the first signal line SL_M1 and the second signal line SL_M2 may be provided in plurality, which are arranged alternately in the first direction DR1.

The first signal line SL_M1 and the second signal line SL_M2 may have different lengths extending in the second direction DR2. For example, the pad part PP_M of the first signal line SL_M1 may be disposed farther from the inspection area PAD_F than the pad part PP_M of the second signal line SL_M2.

The sub-signal lines SL_T may include a first sub-signal line SL_T1 and a second sub-signal line SL_T2. Each of the first sub-signal line SL_T1 and the second sub-signal line SL_T2 may be provided in plurality, which are arranged alternately in the first direction DR1.

The first sub-signal line SL_T1 and the second sub-signal line SL_T2 may have different lengths extending in the second direction DR2. For example, the first end E1 of the first sub-signal line SL_T1 may be disposed further away from the inspection area PAD_F than the first end E1 of the second sub-signal line SL_T2.

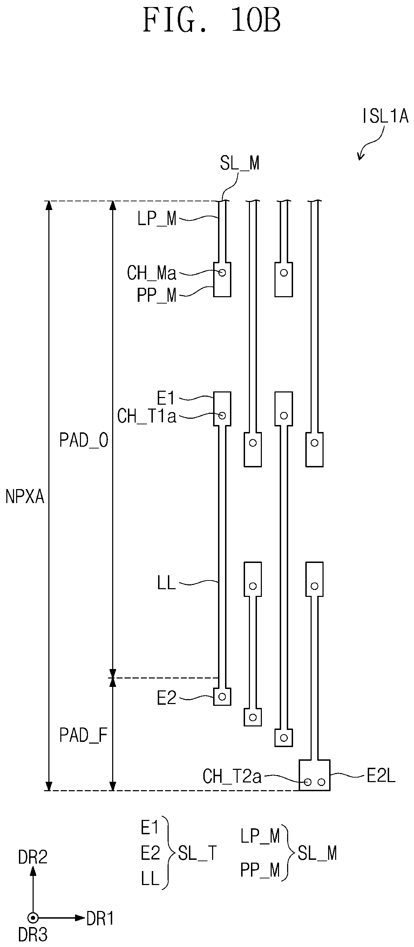

Referring to FIG. 10B, a first insulating layer ISL1A may be disposed on the first conductive layer MSL-L1A. FIG. 10B illustrates a plurality of contact holes CH_Ma, CH_T1a, and CH_T2a defined in the first insulating layer ISL1A. The first insulating layer ISL1A may correspond to the third insulating layer 30 (see FIGS. 5B and 6F) described above. Thus, the contact holes CH_Ma, CH_T1a, and CH_T2a may be formed at the same time as the contact holes shown in FIG. 6F, but are not limited thereto.

The contact holes CH_Ma, CH_T1a, and CH_T2a may respectively correspond to the contact holes CH_M, CH_T1, CH_T2 illustrated in FIG. 9B. Specifically, the first main contact hole CH_Ma may be defined to overlap the pad part PP_M. The first main contact hole CH_Ma may expose at least a portion of the pad part PP_M.

The first-first sub-contact hole CH_T1a may be defined to overlap the first end E1. The first-first sub-contact hole CH_T1a may expose at least a portion of the first end E1.

The second-first sub-contact hole CH_T2a may be defined to overlap the second ends E2 and E2L. The second-first sub-contact hole CH_T2a may expose at least a portion of the second ends E2 and E2L. The second-first sub-contact hole CH_T2a may be provided in plurality to correspond to the large area of the second end E2L.

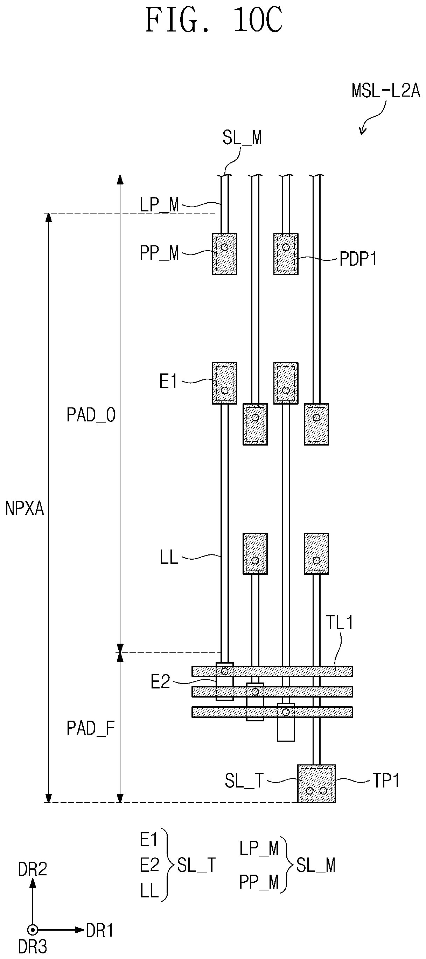

Referring to FIG. 10C, a second conductive layer MSL-L2A may be disposed on the first insulating layer ISL1A. The second conductive layer MSL-L2A may be formed simultaneously with the first conductive patterns CPT1a, CPT1b, CPT1c, and CPT1d illustrated in FIG. 5B. The second conductive layer MSL-L2A may correspond to the third conductive layer MSL3 illustrated in FIG. 6G. The second conductive layer MSL-L2A may include a first pad PDP1, a sub-line TL, and a first sub-pad TP1.

The first pad PDP1 may be provided in plurality, which are arranged to be spaced apart from each other. Each first pad PDP1 may overlap the pad part PP_M or the first end E1 on the plane. Each first pad PDP1 may be connected to the overlapping pad part PP_M through the first main contact hole CH_Ma, or may be connected to the overlapping first end E1 through the first sub-contact hole CH_T1a.

The sub-line TL may extend in the first direction DR1. The sub-line TL may be provided in plurality. The plurality of sub-lines TL may be arranged to be spaced apart from each other in the second direction DR2. Each sub-line TL may overlap each second sub-contact hole CH_T2a. Each sub-line TL may be connected to the corresponding second end E2 through the overlapping second sub-contact hole CH_T2a.

The first sub-pad TP1 may be disposed to overlap the large-area second end E2L. The first sub-pad TP1 may be provided with a larger area than the second end E2L. The first sub-pad TP1 may be connected to the sub-signal line SL_T through a plurality of second sub-contact holes overlapping the large second end E2L.

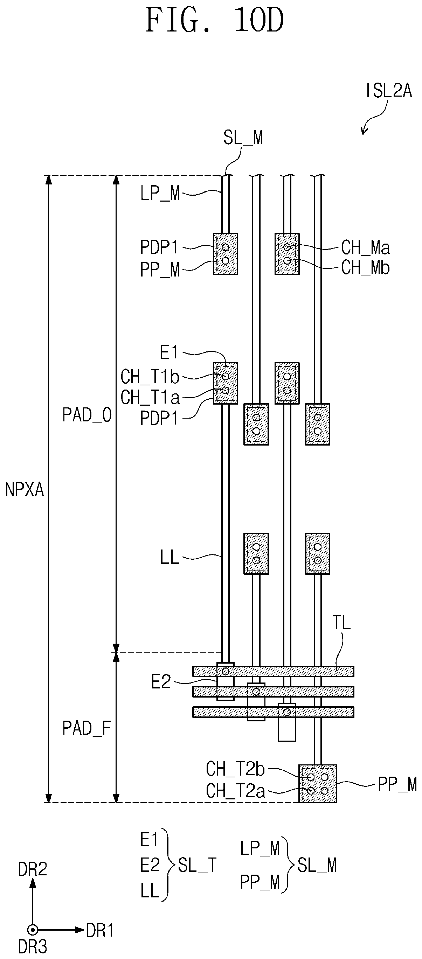

Referring to FIG. 10D, a second insulating layer ISL2A may be disposed on the second conductive layer MSL-L2A. FIG. 10D illustrates contact holes CH_Mb, CH_T1b, and CH_T2b defined in the second insulating layer ISL2A. The second insulating layer ISL2A may correspond to the first inorganic layer 40 (see FIG. 5B) illustrated in FIG. 5B. Thus, the contact holes CH_Mb, CH_T1b, and CH_T2b may be formed at the same time as the contact holes illustrated in FIG. 6H, but are not limited thereto.

The second main contact hole CH_Mb may be defined to overlap the first pad PDP1 and the pad part PP_M. The second main contact hole CH_Mb may be spaced apart from the first main contact hole CH_Ma on the plane. The first main contact hole CH_Ma may expose at least a portion of the first pad PDP1.

The first-second sub-contact hole CH_T1b may be defined to overlap the first pad PDP1 and the first end E1. The first-second sub-contact hole CH_T1b may be spaced apart from the first-first sub-contact hole CH_T1a on the plane. The first-second sub-contact hole CH_T1b may expose at least a portion of the first pad PDP1.

The second-second sub-contact hole CH_T2b may be defined to overlap the first sub-pad TP1 and the large-area second end E2L. The second-second sub-contact hole CH_T2b may be spaced apart from the second-first sub-contact hole CH_T2a on the plane. The second-second sub-contact hole CH_T2b may expose at least a portion of the first sub-pad TP1. The second-second sub-contact hole CH_T2b may be provided in plurality to correspond to the large area of the second end E2L.

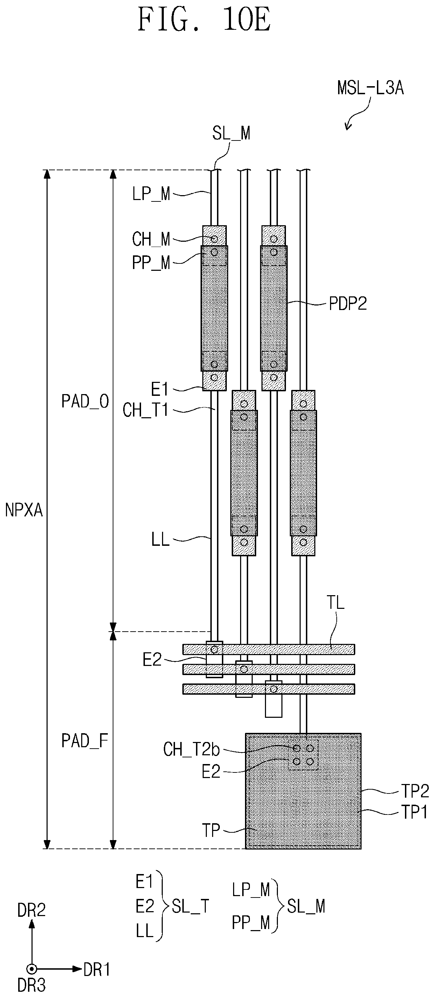

Referring to FIG. 10E, a third conductive layer MSL-L3A may be disposed on the second insulating layer ISL2A. The third conductive layer MSL-L3A may be formed simultaneously with the second conductive patterns CPT2a, CPT2b, and CPT2c illustrated in FIG. 5B. The third conductive layer MSL-L3A may correspond to the fourth conductive layer MSL4 illustrated in FIG. 6J. The third conductive layer MSL-L3A may include a second pad PDP2 and a second sub-pad TP2.

The second pad PDP2 may be provided in plurality, which are arranged to be spaced apart from each other in the first direction DR1. Each second pad PDP2 may connect the main signal line SL_M to the sub-signal line SL_T, which are spaced apart from each other in the second direction DR2. One side of the second pad PDP2 may overlap the pad part PP_M and be connected to the first pad PDP1 through the second main contact hole CH_Mb so as to be connected to the pad part PP_M. The other side of the second pad PDP2 may overlap the first end E1. The second pad PDP2 may be connected to the first pad PDP1 through the first-second sub-contact hole CH_Tb so as to be connected to the first end E1.

The second sub-pad TP2 may be disposed to overlap the large second end E2L and the first sub-pad TP1. The second sub-pad TP2 may be provided with a larger area than the first sub-pad TP1. The sub-pad TP may be connected to the sub-signal line SL_T through a plurality of second sub-contact holes overlapping the large second end E2L.

According to an embodiment of the inventive concept, when forming the fourth conductive layer MSL4, electrical connection may be implemented between the sub-signal lines SL_T and the main signal lines SL_M. Thus, before an OLB process for coupling with the circuit board, an electrical inspection may be performed on the pixels connected to the signal lines SL_M through the second sub-pad TP2 or the sub-line TL. In addition, even if defects occur through the electrical inspection, immediate repair may be easily performed. Therefore, according to an embodiment of the inventive concept, the electrical inspection of the display panel during the process may be easily performed to improve the electrical reliability of the display panel and improving the process reliability.

In addition, according to an embodiment of the inventive concept, the first pads PDP1 may be added separately, and thus, the second pad PDP2 may be connected through the first pad PDP1 without being directly connected to the sub-signal line SL_T or the main signal line SL_M. Thus, even if an area of the ends PP_M, EL1, and EL2 defined in the sub-signal line SL_T or the main signal line SL_M is small, the first pad PDP1 having a larger area may be additionally provided, and the connection to the second pad PDP2 may be performed through the first pad PDP1, and thus, the connection between the sub-signal line SL_T and the main signal line SL_M may be easily performed.

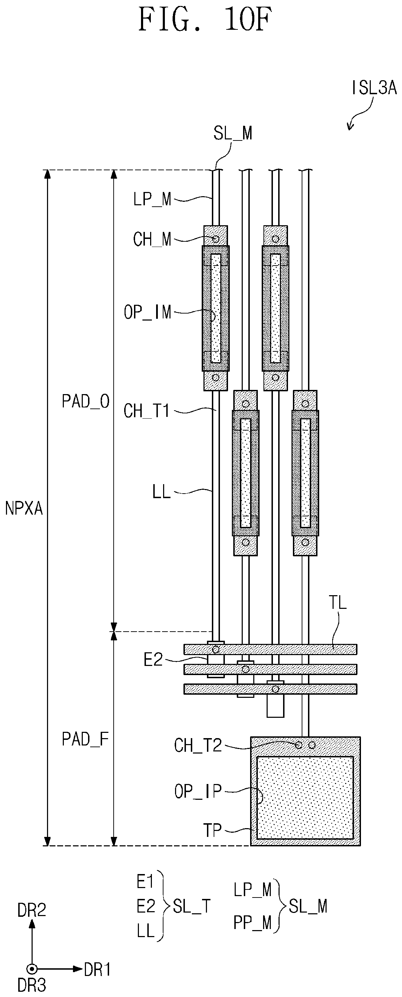

Referring to FIG. 10F, a third insulating layer ISL3A may be disposed on the third conductive layer MSL-L3A. FIG. 10F illustrates a plurality of openings OP_IM and IP_IP defined in the third insulating layer ISL3A. The third insulating layer ISL3A may correspond to the second inorganic layer 60 illustrated in FIG. 5B. Thus, the openings OP_IM and IP_IP may be formed simultaneously with the contact holes and openings illustrated in FIG. 6K.

The pad-opening OP_IM may be defined to overlap each second pad PDP2. The pad-opening OP_IM may expose at least a portion of the second pad PDP2. The pad-opening OP_IM may correspond to the pad-opening HH-P illustrated in FIG. 8A. That is, the second pad PDP2 and the external circuit board may be electrically connected through the pad-opening OP_IM.

The sub-opening OP_IP may be defined to overlap the second sub-pad TP2. The sub-opening OP_IP may expose at least a portion of the second sub-pad TP2. The sub-opening OP_IP may be an area on which the second sub-pad TP2 and an external inspection device are electrically connected. According to an embodiment of the inventive concept, the sub-opening OP_IP having a relatively large area compared to the pad-opening OP_IM may be provided, a tip part of the inspection device, etc. may be easily connected to the second sub-pad TP2. That is, according to an embodiment of the inventive concept, the electrical inspection may be possible even after forming the third insulating layer ISL3A.

The sub-opening OP_IP may be formed simultaneously with the pad-opening OP_IM. In addition, the sub-opening OP_IP and the pad-opening OP_IM may be formed at the same time as the above-described opening HH (see FIG. 5B) by being defined in the second inorganic layer 60. According to an embodiment of the inventive concept, the process may be simplified, and the process cost may be reduced by simultaneously forming the inspection pad, the connection pad, and the hole for discharging the gas.

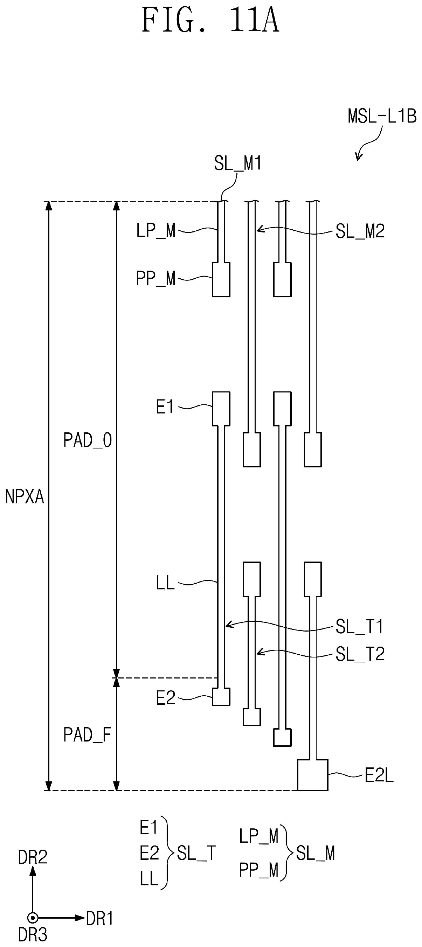

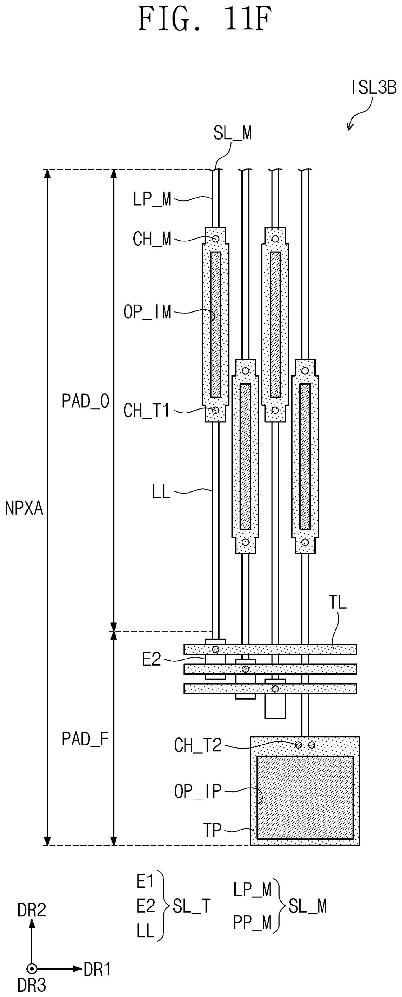

FIGS. 11A to 11F are plan views illustrating a partial area of the display panel of the display panel according to an embodiment of the inventive concept. FIGS. 11A to 11F illustrate the same area as FIGS. 10A to 10F, and some components are omitted for ease of explanation. Hereinafter, the inventive concept will be described with reference to FIGS. 11A and 11F.

Referring to FIG. 11A, a first conductive layer MSL-L1B may include main signal lines SL_MA and sub-signal lines SL_TA. In this embodiment, the first conductive layer MSL-L1B may be a layer formed simultaneously with the lower conductive patterns LPT1, LPT2, and LPT3 illustrated in FIG. 5B and correspond to the first conductive layer MSL1 illustrated in FIG. 6A. The main signal lines SL_MA may include a first signal line SL_M1 and a second signal line SL_M2. Each of the first signal line SL_M1 and the second signal line SL_M2 may be provided in plurality, which are arranged alternately in the first direction DR1. The first conductive layer MSL-L1B may correspond to the first conductive layer MSL-L1A illustrated in FIG. 10A. Hereinafter, duplicated descriptions will be omitted.

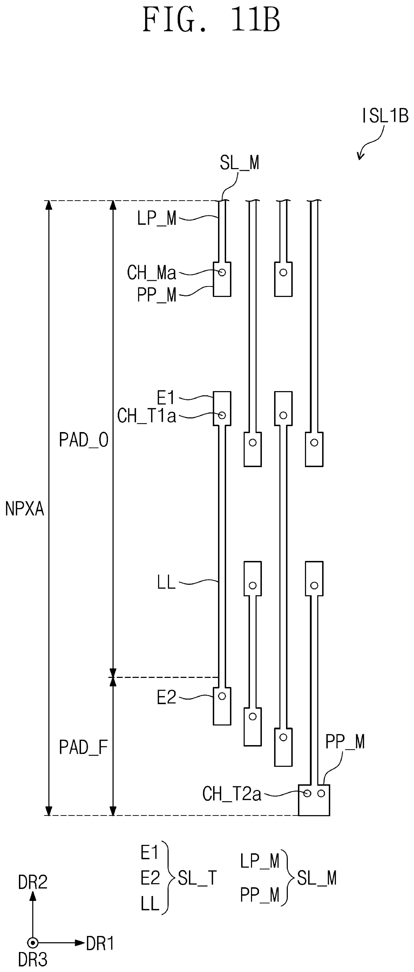

Referring to FIG. 11B, a first insulating layer ISL1B may be disposed on the first conductive layer MSL-L1B. FIG. 11B illustrates a plurality of contact holes CH_Ma, CH_T1a, and CH_T2a defined in the first insulating layer ISL1B. The first insulating layer ISL1B may correspond to the third insulating layer 30 (see FIGS. 5B and 6F) described above. Thus, the contact holes CH_Ma, CH_T1a, and CH_T2a may be formed at the same time as the contact holes shown in FIG. 6F, but are not limited thereto. The first insulating layer ISL1B may correspond to the first insulating layer ISL1A illustrated in FIG. 10B. Hereinafter, duplicated descriptions will be omitted.

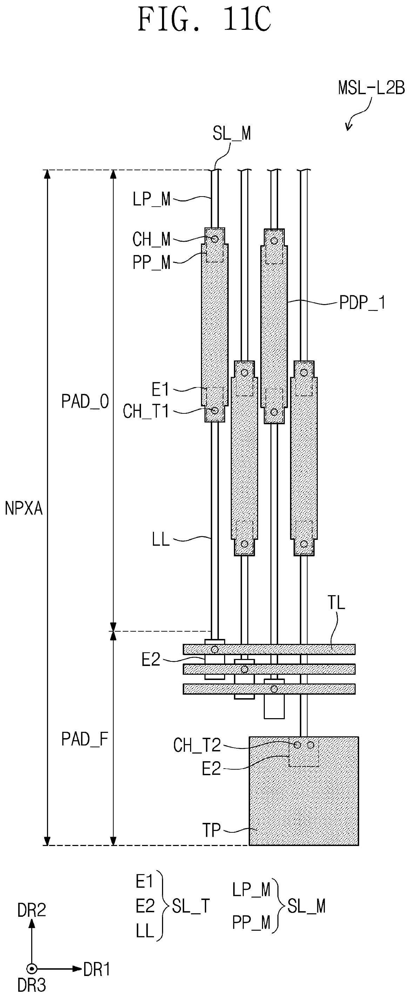

Referring to FIG. 11C, a second conductive layer MSL-L2B may be disposed on the first insulating layer ISL1B. The second conductive layer MSL-L2B may be formed simultaneously with the first conductive patterns CPT1a, CPT1b, CPT1c, and CPT1d illustrated in FIG. 5B. The second conductive layer MSL-L2B may correspond to the third conductive layer MSL3 illustrated in FIG. 6G. The second conductive layer MSL-L2B may include a pad PDP_1, a sub-line TL, and a sub-pad TP.

The pad PDP_1 may be provided in plurality, which are arranged to be spaced apart from each other in the first direction DR1. Each pad PDP may connect the main signal line SL_M to the sub-signal line SL_T, which are spaced apart from each other in the second direction DR2. One side of the pad PDP_1 may overlap the pad part PP_M and be connected to the pad part PP_M through the first main contact hole CH_M. The other side of the pad PDP_1 may overlap the first end E1 and be connected to the first end E1 through the first sub-contact hole CH_T1.

According to this embodiment, the pad PDP_1 may have a shape with different widths in the second direction DR2. For example, the pad PDP_1 may have a shape in which each of a portion that overlaps the pad part PP_M and is connected by the main contact hole CH_M and a portion that overlaps the first end E1 and is connected by the first sub-contact hole CH_T1 has a relative narrow width, and a portion that is disposed between the above-described portions and does not overlap the line parts LP_M and LL has a relative large width. A portion of the pad PDP_1 having a relatively large area may correspond to a portion at which the pad-opening OP_IM (see FIG. 11F) will be formed later.

The sub-line TL may extend in the first direction DR1. The sub-line TL may be provided in plurality. The plurality of sub-lines TL may be arranged to be spaced apart from each other in the second direction DR2. Each sub-line TL may overlap each second end E2. Each sub-line TL may be connected to the corresponding second end E2 through the second sub-contact hole CH_T2.

The sub-pad TP may be disposed to overlap the large area of the second end E2L. The sub-pad TP may be provided with an area greater than that of the second end E2L. The sub-pad TP may be connected to the sub-signal line SL_T through a plurality of second sub-contact holes overlapping the large second end E2L.

According to an embodiment of the inventive concept, when forming the third conductive layer MSL3, electrical connection between the sub-pad TP, the sub-line TL, and the main signal lines SL_M may be already implemented. Thus, before the formation of the first inorganic layer 40 (see FIGS. 5B and 6H), which is performed later, electrical inspection for the pixels connected to the signal lines SL_M may be performed through the sub-pad TP or sub-line TL. In addition, even if defects occur through the electrical inspection, immediate repair may be easily performed. Therefore, according to an embodiment of the inventive concept, the electrical inspection of the display panel during the process may be easily performed to improve the electrical reliability of the display panel and improving the process reliability.

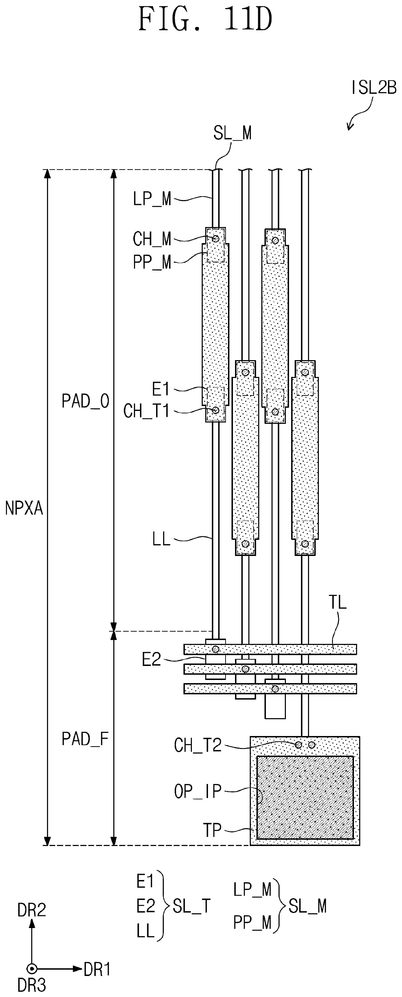

Referring to FIG. 11D, a second insulating layer ISL2B may be disposed on the second conductive layer MSL-L2B. FIG. 11D illustrates an opening OP_IP (hereinafter, referred to as a sub-opening) defined in the second insulating layer ISL2B. The second insulating layer ISL2B may correspond to the first inorganic layer 40 (see FIG. 5B) illustrated in FIG. 5B. Thus, the sub-opening OP_IP may be formed simultaneously with the contact holes illustrated in FIG. 6H, but is not limited thereto.

According to an embodiment of the inventive concept, the sub-pad TP may be exposed through the sub-opening OP_IP defined when forming the first inorganic layer 40 (see FIG. 5B). The display panel according to an embodiment of the inventive concept may be connected to an electrical device for inspection through the exposed sub-pad TP. Thus, the electrical inspection of the pixels may be performed even after forming the first inorganic layer 40 and before proceeding with the next process. In addition, even if defects occur through the electrical inspection, immediate repair may be easily performed. Therefore, according to an embodiment of the inventive concept, the electrical inspection of the display panel during the process may be easily performed in several processes to improve the electrical reliability of the display panel and improving the process reliability.

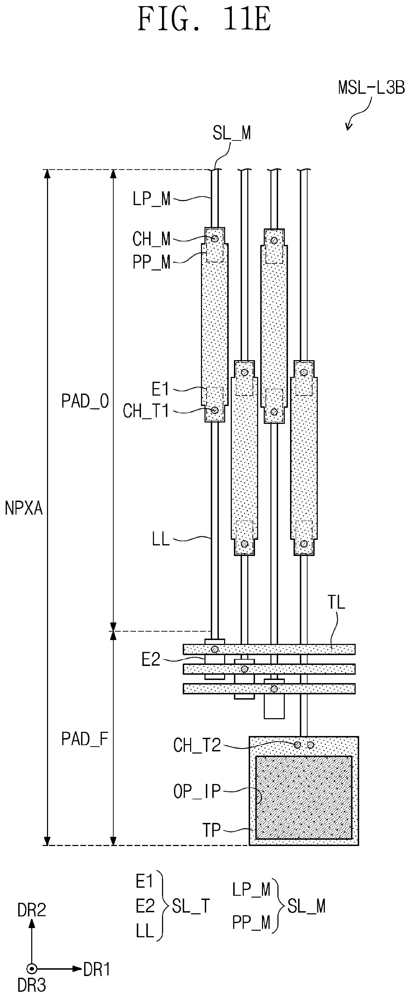

Referring to FIG. 11E, a third conductive layer MSL-L3B may be disposed on the second insulating layer ISL2B. The third conductive layer MSL-L3B may be a layer formed simultaneously with the second conductive patterns CPT2a, CPT2b, and CPT2c illustrated in FIG. 5B and may correspond to the fourth conductive layer MSL4 illustrated in FIG. 6J. In this embodiment, the third conductive layer MSL-L3B disposed on the non-emissive portion NPXA may be omitted. That is, the third conductive layer MSL-L3B may not include a conductive pattern disposed on the non-emissive portion NPXA. Therefore, a state of the non-emission portion NPXA in the process of forming the third conductive layer MSL-L3B may be the same as that of the non-emission portion NPXA in the process of forming the second insulating layer ISL2B illustrated in FIG. 11D.

Referring to FIG. 11F, the third insulating layer ISL3B may be formed after forming the third conductive layer MSL-L3B. FIG. 11F illustrates an opening OP_IM (hereinafter, referred to as a pad-opening) defined in the third insulating layer ISL3B. The third insulating layer ISL3B may correspond to the second inorganic layer 60 illustrated in FIG. 5B. Thus, the pad-opening OP_IM may be formed simultaneously with the contact holes and openings illustrated in FIG. 6K.

The pad-opening OP_IM may be defined to overlap each pad PDP_1. The pad-opening OP_IM may expose at least a portion of pad PDP_1. The pad PDP_1 and an external circuit board may be electrically connected through the pad-opening OP_IM.

That is, the pad-opening OP_IM may be defined to pass through not only the third insulating layer ISL3B but also the second insulating layer ISL2B. The second insulating layer ISL2B and the third insulating layer ISL3B may be etched simultaneously through the same process to form the pad-opening OP_IM. Thus, it may correspond to the pad-opening PD-OP illustrated in FIG. 11F, and the exposed pad PDP_1 may correspond to the pad PDP-A illustrated in FIG. 11F.

According to an embodiment of the inventive concept, as the pad-opening OP_IM is defined when forming the third insulating layer ISL3B, in the process of forming third conductive layer MSL-L3B before forming the third insulating layer ISL3B, the pad-opening OP_IM may be covered by the second insulating layer ISL2B and the third insulating layer ISL3B without exposing the pad PDP-A. The second insulating layer ISL2B and the third insulating layer ISL3B may protect the pad PDP_1 when patterning the third conductive layer MSL-L3B. Thus, the exposure of the pad PDP_1 to etchant for forming the second conductive patterns CPT2a, CPT2b, and CPT2c (see FIG. 5B) may be prevented, and damage to the pad PDP_1 during the process may be prevented. Thus, process efficiency may be improved.

In addition, the third insulating layer ISL3B and the second insulating layer ISL2B may be simultaneously patterned when forming the pad-opening OP_IM to simplify the process for forming the pad PDP-A and reduce the process costs. This is merely an example, and if the pixel formation process on the emitting area PXA and the process of forming the pad PDP_1 or the inspection pad TP on the non-emission area NPXA are performed simultaneously, various methods may be used, but are not limited to any one embodiment.

Although the present invention has been described with reference to preferred embodiments thereof, those skilled in the pertinent art or those having ordinary skill in the pertinent art will understand that various modifications and changes may be made to the present invention without departing from the spirit and technical scope of the present invention as set forth in the appended claims. Accordingly, the technical scope of the present invention should not be limited to the description set forth in the Detailed Description of the Specification, but should be defined by the appended claims.

### [Industrial Applicability]

The present invention is industrially applicable as it relates to a technology that improves the process reliability of a display panel.

## Claims

1. A display panel comprising:
a substrate comprising a display area and a peripheral area adjacent to the display area;
a transistor disposed in the display area;
a first conductive layer disposed on the transistor and comprising a first connection pattern connected to the transistor;
a first inorganic layer configured to cover the first conductive layer;
a first organic layer disposed on the first inorganic layer;
a second conductive layer disposed on the first organic layer and comprising a second connection pattern that is connected to the first connection pattern by passing through the first inorganic layer and the first organic layer;
a second inorganic layer configured to cover the second conductive layer;
a second organic layer disposed on the second inorganic layer;
a light emitting element disposed on the second organic layer and connected to the second connection pattern;
a contact hole passing through the second inorganic layer to expose at least a portion of the second conductive layer; and
an opening spaced apart from the contact hole on a plane and passing through the second inorganic layer to expose at least a portion of the first organic layer.

2. The display panel of claim 1, wherein the second connection pattern is connected to the first connection pattern through the contact hole.

3. The display panel of claim 1, wherein the second organic layer is in contact with the first organic layer through the opening.

4. The display panel of claim 1, wherein the opening is provided in plurality, which are arranged to be spaced apart from each other.

5. The display panel of claim 4, wherein one and the other of the plurality of openings have different shapes on the plane.

6. The display panel of claim 1, wherein the opening does not overlap the second connection pattern on the plane.

7. The display panel of claim 6, wherein the second conductive layer further comprises a plurality of conductive patterns spaced apart from the second connection pattern on the plane, and
the opening does not overlap the conductive pattern on the plane.

8. The display panel of claim 1, wherein, in the display area, a ratio of an area of the opening on the plane to an area of the second inorganic layer on the plane is about 30% or less.

9. The display panel of claim 1, wherein the first conductive layer further comprises a pad electrically connected to the transistor and disposed in the peripheral area, and
a first pad opening through which the pad is exposed is defined in the first inorganic layer.

10. The display panel of claim 9, wherein the second inorganic layer does not overlap the first pad opening on the plane.

11. The display panel of claim 9, wherein a second pad opening overlapping the first pad opening is defined in the second inorganic layer.

12. The display panel of claim 11, wherein the first pad opening and the second pad opening are aligned with each other on the plane.

13. The display panel of claim 9, wherein each of the first connection pattern and the pad comprises a first sub-layer, a second sub-layer disposed on the first sub-layer, and a third sub-layer disposed on the second sub-layer and comprising a material different from that of the second sub-layer, and
the third sub-layer of the first connection pattern has a thickness different from that of the third sub-layer of the pad.

14. A display panel comprising:
a substrate comprising a display area comprising a plurality of emission areas and a peripheral area adjacent to the display area;
a transistor disposed in each of the emission areas;
a first conductive layer disposed on the transistor and comprising a plurality of first conductive patterns spaced apart from each other;
a first inorganic layer configured to cover the first conductive layer;
a first organic layer disposed on the first inorganic layer;
a second conductive layer disposed on the first organic layer and comprising a plurality of second conductive patterns spaced apart from each other;
a second inorganic layer configured to cover the second conductive layer;
a second organic layer disposed on the second inorganic layer; and
a light emitting element disposed in each of the emission areas, disposed on the second organic layer, and connected to the transistor through a first connection pattern of the first conductive patterns and a second connection pattern of the second conductive patterns,
wherein the second inorganic layer comprises an opening spaced apart from the second conductive patterns on a plane, and
the second organic layer is in contact with the first organic layer through the opening.

15. The display panel of claim 14, wherein the light emitting element is connected to the second connection pattern through a contact hole passing through the second organic layer and the second inorganic layer, and
the opening is spaced apart from the contact hole on the plane.

16. The display panel of claim 15, wherein the opening has an area greater than that of the contact hole.

17. The display panel of claim 14, wherein the opening is defined in each of the emission areas.

18. The display panel of claim 16, wherein the opening is provided in plurality, which are spaced apart from each other within each of the emission areas.

19. The display panel of claim 14, wherein the first conductive layer further comprises a pad disposed in the peripheral area, and
a first pad opening through which the pad is exposed is defined in the first inorganic layer.

20. The display panel of claim 19, wherein a second pad opening overlapping the first pad opening is defined in the second inorganic layer.
